# EUROPEAN PATENT SPECIFICATION

(11) **EP 4 322 718 B1**
(45) Date of publication and mention of the grant of the patent: **14.10.2026**
(21) Application number: 22190164.8
(22) Date of filing: 12.08.2022
(51) Int. Cl.: H05K 7/14

(54) **SLED, ORTHOGONAL-DIRECT CHASSIS, AND METHODS**
SCHLITTEN, ORTHOGONAL-DIREKTES CHASSIS UND VERFAHREN
COULISSE, CHÂSSIS ORTHOGONAL-DIRECT, ET PROCÉDÉS

(43) Date of publication of application: 14.02.2024
(73) Proprietor: ExpectedIT GmbH, 73728 Esslingen am Neckar (DE)
(72) Inventor: STEINMACHER-BUROW, Burkhard, 73728 Esslingen am Neckar (DE); INGIMUNDARSON, Arni, 76137 Karlsruhe (DE)
(74) Representative: Witte, Weller & Partner Patentanwälte mbB

(56) References cited:
- EP-A1- 3 367 766
- EP-A1- 3 509 406

## Description

### Background of the invention

The present invention relates to a sled for an orthogonal-direct, OD, chassis. Further, the present invention relates to an orthogonal-direct, OD, chassis. Further, the present invention relates to methods for inserting a sled in an OD chassis. Further, the present invention relates to methods for removing a sled from an OD chassis. Further, the present invention relates to methods for replacing a sled in an OD chassis. Further, the present invention relates to a method for assembling a sled for an OD chassis.

Orthogonal-direct (OD) chassis are known in the technical field of data centers. In general, a data center is a building, a dedicated space within a building, or a group of buildings used to house computer systems and associated components, such as telecommunications and storage systems. In particular, the computer systems as well as the associated components can be arranged in racks within the data center.

For instance, a data center rack can hold a chassis which is populated with removable sleds. With other words, the chassis is a frame or a housing in which the sleds can be arranged, in particular mounted. A sled is a unit or module that is insertable into the chassis. In particular, the chassis can comprise slots, wherein each sled can be inserted into one of the slots of the chassis. The sled preferably includes hardware components of the computer systems and/or the associated components.

One type of chassis of data center racks is an orthogonal-direct (OD) chassis. The OD chassis holds horizontal sleds inserted from the front of the rack and holds vertical sleds inserted from the rear of the rack. Each of the front sleds and the rear sleds comprises connection elements. When the front sleds and the rear sleds are inserted into the chassis, the connection elements establish an OD connection between the front sleds and the rear sleds. With other words, when the sleds are inserted into the chassis, each front sled connects to each rear sled using an OD connector. For instance, each front sleds can comprise multiple sockets as connection elements at a rear side of each front sled, and each rear sled can comprise multiple plugs as connection elements at a front side of each rear sled.

For instance, document US 10,841,246 B2 shows a network device. The device includes a housing and a switch card, mounted within the housing and having one or more connectors. A plurality of line cards is oriented parallel to each other and orthogonal to the switch card and assembled to the one or more connectors of the switch card. The switch card has a chip, with a plurality of switches or routing paths, and the switch card and the chip couple to the plurality of line cards through the one or more connectors.

Further, document EP 3 509 406 A1 relates to an adaptable rack chassis for accommodating electronic component sleds of differing widths and heights. One example chassis includes side walls and a back wall with registration features at different heights. Shelves may be attached to the registration features at different heights. The front end of the side walls may be attached to shelves at different heights. Another example chassis may have an adaptable horizontal bus bar structure that is located to the back of two side walls. Another example chassis may have vertical bus bar structure that may be adjusted over the width between side walls.

Further, document EP 3 367 766 A1 relates to a sled to facilitate connection of the electrical components housed therein to a backplane located in a chassis. The sled includes a housing with a front portion and a rear portion connected by a base portion. The base portion includes a plurality of electronic unit modules. The sled also includes a connector laterally slidable with respect to the front portion of the housing. The connector is slidably configured to connect the electronic unit modules to a backplane located in the server rack.

Up to now, in OD chassis, each socket or plug has a fixed mounting on its sled so that it blind-mates with its counterpart when the sled is inserted into the chassis. The fixed mounting of each socket and each plug causes all of the front and rear sleds to effectively act as a single large fixed mechanical structure. For a chassis with many sleds or wide sleds, this single structure can be overly large and thus cause problems.

In a single fixed mechanical structure, there are several mechanical forces and tensions present due the design of the single fixed mechanical structure. For instance, the mechanical forces and tensions can be caused by torque forces proportional to the length, shock waves and vibrations, thermal expansion gradients, mechanical tolerances, and the weight of structure or of components in the structure. The larger the size and weight of the OD chassis is, the larger the mechanical forces and tensions become.

Thus, when an OD chassis increases in weight and size, in particular carries a larger number of sleds and/or bigger and heavier sleds, the mechanical forces and tensions within the OD chassis also increase. These mechanical forces and tensions particularly affect the connection elements (e.g. the plugs and the sockets) of the OD connection. In particular, when the OD chassis increases in size or weight, the connection elements might be damaged. Moreover, when large or heavy sleds are inserted, the risk increases that the connection elements are damaged due to the larger mechanical forces present during the insertion. Thus, as a consequence of the current design of OD chassis as single fixed mechanical structure, the mechanical forces and tensions cause particular limitations in fabricating OD chassis, in particular limitations with regard to the size, the weight and the number of sleds.

### Summary of the invention

Against this background, it is an object of the present invention to provide an improved sled for an OD chassis and an improved OD chassis having an improved mechanical stability. In particular, it is an object to provide a sled for an OD chassis and an OD chassis by which the mechanical stability of the connection elements is improved.

It is another object to provide improved methods for removing, inserting and replacing a sled in an OD chassis. In particular, it is an object to provide improved methods by which a sled can be safely removed, inserted or replaced in an OD chassis without causing damage to the connection elements.

According to a first aspect of the invention, there is provided a sled for an orthogonal-direct, OD, chassis, wherein the sled comprises:
- a frame;
- a plurality of connection elements for establishing an OD connection with one or more other sleds of the OD chassis; and
- one or more segments, each segment comprising a first part,
wherein each segment is arranged within the frame, wherein one or more of the connection elements are mounted to the first part of each segment, and wherein the first part of each segment is movable relative to the frame.

The sled according to the invention (in the following briefly referred to as the new sled) is a unit or module that is insertable into the OD chassis. In particular, the OD chassis can comprise slots, wherein the sled can be inserted into one of the slots. In the OD chassis, the new sled can be used as a horizontal sled or a vertical sled. In particular, the new sled can be fastened to the OD chassis when it is inserted into the slot. For fastening the new sled to the OD chassis, different types of fasteners could be used, for example bolts or levers. The sled preferably includes electronic components that can be connected in the OD chassis to other components such as other sleds, processing units, a power supply, a network, and the like.

In an OD chassis, several types of sleds can be used. For instance, an OD chassis can comprise processor sleds, a fabric sleds and/or utility sled. In an OD chassis, processor sleds are preferably horizontal sleds at a front side of the OD chassis, while fabric sleds and utility sleds are preferably vertical sleds at a rear side of the OD chassis. The processor sled can include one or more processor units. The processor unit can be connected to memory devices or storage devices or accelerator devices or other devices which can be included within the sled. The processor sled can be configured to process data or to run applications. The processor sled can be configured as a device sled. The device sled can include one or more interface units. The interface unit may be a processor unit. The interface unit can provide access to memory devices or storage devices or accelerator devices or other devices which can be included within the sled. The fabric sled is configured to allow, in particular manage, exchange of data between a plurality of processor sleds. In particular, the fabric sled connects all processor sleds to each other. The fabric sled can comprise one or more fabric chips that manage the exchange of data, wherein each processor sled is connected to the fabric chip. The utility sled is configured to provide utilities within the OD chassis. In particular, the utility sled can be configured to distribute utilities to a plurality of processor sleds. The utilities can be electric power, hardware management, communication (e.g. Ethernet and network access), light, cooling liquid, and the like. For instance, the new sled can be a processor sled, a fabric sled, or a utility sled. The new sled is preferably a fabric sled or a utility sled.

The new sled includes a frame, a plurality of connection elements, and one or more segments. The frame is a housing or enclosure that houses the components of the sled. In particular, the connection elements and the one or more segments are arranged within the frame. While a sled is inserted in a chassis, the frame can be fixedly connected with the housing of the OD chassis. In particular, the frame can be fastened to the housing of the OD chassis.

The connection elements are configured to establish the OD connection with one or more other sleds of the OD chassis when the new sled is inserted in the OD chassis. In particular, the connection elements of the new sled can connect with corresponding connection elements of the one or more other sleds of the OD chassis to establish the OD connection. The one or more other sleds of the OD chassis are thus counterparts of the new sled. For instance, the new sled can be a vertical sled of the OD chassis, wherein the one or more other sleds are horizontal sleds of the OD chassis. Alternatively, the new sled can also be a horizontal sled of the OD chassis, wherein the one or more other sleds are vertical sleds of the OD chassis.

For the OD connection, always one connection element of the one or more other sleds connects with one connection element of the new sled. The sled can further comprise connection elements that are not connecting with the one or more other sleds. These additional connection elements can be used providing several of the utilities mentioned above. Thus, the number of connection elements of the new sled can be equal to or higher than the number of the one or more other sleds.

The sled can comprise one segment. Alternatively, the sled can comprise a plurality of segments. The new sled can also be called a segmented sled because it has one or more segments. Each segment is arranged within the frame. In particular, each segment can be mounted within the frame in some manner.

Each segment has one or more parts. The parts of the segments can include a segment board and/or a segment housing. In particular, each segment has at least a first part. The first part is preferably a segment board. Alternatively, the first part can also be a segment housing. Each segment can also comprise more parts, for example a second part, a third part, and the like.

One or more of the connection elements are mounted to the first part of each segment. With other words, the first part of each segment comprises a subset of the plurality of connection elements of the new sled. In case that the new sled has only one segment, all of the plurality of connection elements can be mounted to the first part. In case that the new sled has more than one segment, the connection elements can be distributed over the segments. With other words, each segment carries a subset of the plurality of connection elements. Alternatively, also one or more connection elements could be directly mounted to the frame - and the remaining connection elements are then carried by the segments (either to by one or distributed over all segments).

The connection elements are consecutively arranged on the first part in a direction along a side of the sled. In case that the new sled has more than one segment, the segments are consecutively arranged in this direction as well.

According to the first aspect, at least the first part of each segment of the new sled is movably relative to the frame. In particular, the first part of the segment is mounted within the frame in such a way that it is movable relative to the frame. With other words, the first part of each segment is not fixedly or firmly mounted to the frame but is movable in some manner. The movement relative to the frame can be any linear or rotational motion relative to the frame. The segments can be configured in such a way that only the first part of each segment is movable relative to the frame. Alternatively, the entire segments could be movable relative to the frame. In this case, the first part is movable together with the entire segment relative to the frame.

As the connection elements are mounted to the first part of each segment, the connection elements move together with the first part relative to the frame. Therefore, the frame, the segments and the connection elements do not form a single fixed mechanical structure because the connection elements are somewhat mechanically decoupled from the frame. Thus, when the new sled is inserted into an OD chassis, mechanical forces and tensions affecting the connection elements of the OD connection are reduced. Thereby, the mechanical stability of the connection elements and the OD connection is improved.

Particularly, when the new sled comprises a plurality of segments, the sleds total mating force is broken up into the mating force of each segment. Each connection element can have many pins and if the sled has many connection elements, this can sum to an overly-large insertion-force or mating-force which causes mechanical problems and/or human-operator problems when the sled's connection elements mate with their counterparts in the one or more other sleds. By enabling a segment to mate, independently of the sled and independently of the sled's other segments, the insertion force is just the insertion force of each segment.

According to a second aspect of the invention, there is provided an orthogonal-direct, OD, chassis, comprising:
- one or more horizontal sleds; and
- one or more vertical sleds,
wherein each horizontal sled is connectable to each vertical sled using an OD connection, and wherein the one or more horizontal sleds and/or the one or more vertical sleds are configured as sleds according to the first aspect.

In particular, the OD chassis is an OD chassis for a data center rack. For instance, the data center rack can comprise the OD chassis. The OD chassis can comprise a housing or enclosure that includes slots in which sleds can be inserted. The sleds can be inserted from the front side and from the rear side of the OD chassis. The slots at the front side of the chassis extend in a horizontal direction. The slots at the rear side extend in a vertical direction.

When sleds are inserted into the slots at the front side of the OD chassis, the sleds are horizontally arranged. These sleds are called horizontal sleds or front sleds. The OD chassis can comprise one or more horizontal sleds. The horizontal sleds are preferably processor sleds. In particular, the OD chassis can comprise four, eight, 16, or 32 processor sleds.

When sleds are inserted into the slots at the rear side of the OD chassis, the sleds are vertically arranged. These sleds are called vertical sleds or rear sleds. The OD chassis can comprise one or more vertical sleds. The vertical sleds are preferably fabric sleds and/or utility sleds. In particular, the OD chassis can comprise four, six, eight, 16, or 32 fabric sleds. The number of fabric sleds can be equal to or less than the number of processor sleds. In addition, to the fabric sleds, one vertical sled can also be an utility sled.

The horizontal sleds and the vertical sleds are connected among each other via an OD connection. In particular, each horizontal sled is connectable to each vertical sled using the OD connection.

Preferably, each vertical sled is configured as the new sled according to the first aspect. Additionally or alternatively, each horizontal sled is configured as the new sled according to the first aspect. Thereby, the mechanical stability of the connection elements and the OD connection is improved.

For cooling the sleds of the OD chassis, in particular the processor sleds of the OD chassis, the sleds, in particular the vertical (rear) sleds, can further comprise one or more fan units. In particular, for each segment, each (vertical) sled can further comprise one or more fan units that can be mounted to the segment. The fan units can be field-replaceable rear fans. Alternatively, the OD chassis can comprise a fan tray arranged on top of a rear-side of the chassis. The fan tray can be configured to blow or pull air through the vertical (rear) sleds of the OD chassis, wherein the airflow continues through the horizontal (front) sleds of the OD chassis. Alternatively, liquid cooling could be used for cooling the sleds, in particular the processor sleds. The liquid cooling can be provided as a utility. In particular, liquid connectors and pipes can be used to distribute the liquid of the liquid cooling. For example, each processor sled can comprise two blind-mate liquid connectors, one for inflow and one for outflow of the liquid. The connector counterpart can be on a utility sled or a part of the OD chassis.

According to a third aspect of the invention, there is provided a method for inserting a sled into an OD chassis, wherein the sled establishes an OD connection with one or more other sleds of the OD chassis when the sled is inserted in the OD chassis, wherein the sled is configured as a sled according to the first aspect, wherein the first part of each segment is movable parallel to a movement direction between an advanced position and a retracted position, wherein the method comprises the following steps:
- arranging the first part of each segment of the sled in the retracted position;
- inserting the sled into the OD chassis; and
- moving the first part of each segment of the sled from the retracted position to an advanced position, thereby establishing the OD connection with the one or more other sleds of the OD chassis.

In particular, each segment or the first part of each segment are mounted within the frame in such a way that the first part is movable parallel to the movement direction between the advanced position and the retracted position The movement direction can also be called connection or connecting direction. In the advanced position, the connection elements are arranged in such a way that the OD connection can be established when the sled is inserted into the OD chassis. In the retracted position, the connection elements are arranged in such a way that the OD connection cannot be established when the sled is inserted into the OD chassis. With other words, the connection elements are configured to establish the OD connection when the segment board or the segment is arranged in the advanced position (but not when arranged in the retracted position). The advanced position can also be called operating position. The retracted position can also be called holding or parking position. The advanced position is preferably used during operation of the sled, meaning when the OD connection is to be established. The retracted position is preferably used when the sled is not in operation, in particular when the sled is transported and during insertion and removal of the sled.

In particular, the sled is inserted into an empty slot of the OD chassis. After inserting the sled, the frame of the sled can be fastened to the OD chassis. The sled can comprise one or more fasteners that can be engaged with the OD chassis after the sled is inserted. The fasteners can comprise one or more bolts or one or more levers. For instance, the bolts and levers can be engaged with the housing of the OD chassis. In particular, the OD chassis can comprise corresponding holes with which the bolts or levers can engage.

According to a fourth aspect of the invention, there is provided a method for removing a sled from an OD chassis, wherein the sled establishes an OD connection with one or more other sleds of the OD chassis when the sled is inserted in the OD chassis, wherein the sled is configured as a sled according to the first aspect, wherein the first part of each segment is movable parallel to a movement direction between an advanced position and a retracted position, wherein the method comprises the following steps:
- moving the first part of each segment of the sled from the advanced position to the retracted position, thereby disengaging the OD connection with the one or more other sleds of the OD chassis; and
- removing the sled from the OD chassis.

In particular, the sled is removed from a slot of the OD chassis. Before removing the sled, the frame of the sled can be released from the OD chassis. As described above, the sled can comprise one or more fasteners by which the sled can be fastened to the OD chassis. These fasteners are released before the sled is removed.

According to a fifth aspect of the invention, there is provided a method for replacing a sled in an OD chassis, wherein the method comprises the following steps:
- removing a sled from the OD chassis using the method according to the fourth aspect; and
- inserting a replacement sled in the OD chassis using the method according to the third aspect.

In the methods according to the third to fifth aspect, the new sled is inserted and removed while the first part of the segment is arranged in the retracted position. Further, the OD connection is established or disengaged while the sled is fully inserted in the OD chassis. Thus, only the segments are moved to establish or disengage the OD connection, but not the entire sled. Thereby, the mechanical forces affecting the connection elements during the insertion or removal of the sled are reduced. This is particularly beneficial when the sled is large-sized and heavy. In particular, damaging of the connection elements during insertion or removal of the sled is avoided.

According to a sixth aspect of the invention, there is provided a method for inserting a sled in an orthogonal-direct, OD, chassis, wherein the sled establishes an OD connection with one or more other sleds of the OD chassis when the sled is inserted in the OD chassis, wherein the one or more other sleds are configured as sleds according to the first aspect, wherein the first part of each segment of the one or more other sleds is movable parallel to a movement direction between an advanced position and a retracted position, wherein the method comprises the following steps:
- arranging the first part of each segment of the one or more other sleds in the retracted position;
- inserting the sled into the OD chassis; and
- moving the first part of each segment of the one or more other sleds from the retracted position to the advanced position, thereby establishing the OD connection with the sled.

In particular, the sled is inserted into an empty slot of the OD chassis. After inserting the sled, the frame of the sled can be fastened to the OD chassis. As described above, the sled can comprise one or more fasteners by which the sled can be fastened to the OD chassis.

According to a seventh aspect of the invention, there is provided a method for removing a sled from an OD chassis, wherein the sled establishes an OD connection with one or more other sleds of the OD chassis when the sled is inserted in the OD chassis, wherein the one or more other sleds are configured as sleds according to the first aspect, wherein the first part of each segment of the one or more other sleds is movable parallel to a movement direction between an advanced position and a retracted position, wherein the method comprises the following steps:
- moving the first part of each segment of the one or more other sleds from the advanced position to the retracted position, thereby disengaging the OD connection with the one or more other sleds of the OD chassis; and
- removing the sled from the OD chassis.

In particular, the sled is removed from a slot of the OD chassis. Before removing the sled, the frame of the sled can be released from the OD chassis. As described above, the sled can comprise one or more fasteners by which the sled can be fastened to the OD chassis. These fasteners are released before the sled is removed.

According to an eighth aspect of the invention, there is provided a method for replacing a sled in an OD chassis, wherein the method comprises the following steps:
- removing a sled from the OD chassis using the method according to the seventh aspect; and
- inserting a replacement sled in the OD chassis using the method according to the sixth aspect.

In the methods according to the sixth to eighth aspect, the sled is inserted and removed while the first part of the segment of each of the one or more other sleds is arranged in the retracted position. Further, the OD connection is established or disengaged while the sled is fully inserted in the OD chassis. Thus, only the segments are moved to establish or disengage the OD connection, but not the entire sled. Thereby, the mechanical forces affecting the connection elements during the insertion or removal of the sled are reduced. This is particularly beneficial when the sled is large-sized and heavy. In particular, damaging of the connection elements during insertion or removal of the sled is avoided.

In the methods according to the third to eighth aspect, the OD chassis can the OD chassis according to the second aspect. The sled which is inserted or removed from the OD chassis is then either one of the horizontal sleds or one of the vertical sleds. Accordingly, the one or more other sleds are then either corresponding vertical sleds or corresponding horizontal sleds.

According to a ninth aspect of the invention, there is provided a method for assembling a sled for an orthogonal-direct, OD, chassis, the method further comprising:
- providing a frame;
- providing a plurality of connection elements for establishing an OD connection with one or more other sleds of the OD chassis;
- providing one or more segments, each segment comprising a first part;
- mounting one or more of the connection elements to the first part of each segment;
- arranging each segment within the frame,
wherein the first part of each segment is movable relative to the frame.

With the method according to the ninth aspect a sled is assembled according to the first aspect.

The aspects of the invention avoid the single overly-large fixed structure in order to avoid the resulting problems. The new sled includes one or more segments. Each connection element (plug or socket) is mounted on one of the segments, in particular on the first part. Each segment or at least the first part thereof is physically suspended in the sled such that the segment or the first part has some (preferably limited) physical motion or float with respect to the sled. By this configuration, the components of the sled do not act as a single fixed mechanical structure. Instead, the new sled acts as multiple smaller fixed structures, thereby increasing the mechanical stability of the sled, of the OD chassis, and particularly of the connection elements.

Accordingly, the objective technical problem is fully solved.

In a preferred refinement of any one of the above aspects, each segment or the first part of each segment is movably mounted to the frame.

With other words, either the entire segment or the first part of the segment is mounted to the frame or supported by the frame in such a way that the entire segment or at least the first part of the segment is movable.

In a further refinement of any one of the above aspects, each segment may further comprise a second part, wherein the second part of each segment is mounted to the frame, wherein the first part of each segment is movably mounted to the second part of the corresponding segment.

The second part may be fixedly or firmly mounted to the frame. As the first part is movable relative to the second part, the first part is also movable relative to the frame.

In a further refinement of any one of the above aspects, each segment or the first part of each segment may be mounted in a floating manner within the frame.

In general, floating refers to some kind of (minor) movement in one or more direction, particularly against some kind of pre-tension or resetting forces. For instance, for mounting the segment or the first part of each segment in a floating manner, flexible elements can be used. Either the entire segment or only the first part of the segment can be mounted in the floating manner. Thereby, the first part of each segment and, consequently, also each connection element mounted thereon are mechanically decoupled from the frame. Preferably, when the new sled is inserted into the OD chassis, at least the first part of each segment float is sufficiently small such that the connection elements of the sled blind-mate with their counterparts on the one or more other sleds in the OD chassis. This small float is sufficient such that the sleds connected via the OD connection do not effectively act as a single large fixed mechanical structure, but as multiple smaller fixed structures. Thus, the mechanical stability is further improved.

In a further refinement of any one of the above aspects, each segment or the frame may comprise one or more floating bearings for mounting each segment or the first part of each segment in a floating manner.

With other words, for each segment, a floating bearing is provided by which either the entire segment or only the first part of the segment is mounted in a floating manner. The floating bearings further improve the mechanical stability of the sled. The floating bearings are provided between the frame and the segment or between the frame and the first part of the segment. Preferably, the floating bearings can be mounted on or formed by the frame adjacent to each segment or the first part of each segment. Alternatively, the floating bearings can be mounted on or formed by each segment. The floating bearings can be flexible elements such as flexible spacers, lances, and the like. Preferably, lances are used as the floating bearings.

In a further refinement of any one of the aspects, the first part of each segment may be movable parallel to a movement direction between an advanced position and a retracted position, wherein the OD connection can be established when the first part of each segment is arranged in the advanced position.

In particular, each segment or the first part of each segment are mounted within the frame in such a way that the first part is movable parallel to the movement direction between the advanced position and the retracted position The movement direction can also be called connection or connecting direction. In the advanced position, the connection elements are arranged in such a way that the OD connection can be established when the sled is inserted into the OD chassis. In the retracted position, the connection elements are arranged in such a way that the OD connection cannot be established when the sled is inserted into the OD chassis. With other words, the connection elements are configured to establish the OD connection when the first part is arranged in the advanced position (but not when it is arranged in the retracted position). The advanced position can also be called operating position. The retracted position can also be called holding or parking position. The advanced position is preferably used during operation of the sled, meaning when the OD connection is to be established. The retracted position is preferably used when the sled is not in operation, in particular when the sled is transported and during insertion and removal of the sled. Thereby, the mechanical stability of the sled is further improved. In particular, damaging of the connection elements can be avoided during insertion or removal of the sled into or from the OD chassis.

In a further refinement of any one of the above aspects, the frame may comprise a first side and a second side opposite to the first side, wherein the connection elements are arranged at the first side, wherein the movement direction is parallel to a direction extending from the first side to the second side.

The first side and the second side are opposite to each other in the movement direction. In the retracted position, the connection elements are arranged closer to the second side than in the advanced position. The first side of the frame is at least partially opened so that the connection elements are accessible for the OD connection from the outside of the frame. In particular, the connection elements can protrude in the advanced position out of the frame through this opening. When the new sled is inserted into the OD chassis, the first side faces the one or more other sleds.

In a further refinement of any one of the aspects, the frame may comprise guiding elements extending in the movement direction, wherein the guiding elements guide the movement of each segment or the movement of the first part of each segment in the movement direction.

With other words, each segment or the first part of each segment is mounted to the frame by the guiding elements in such a way that the segment or the first part of the segment is movable in the movement direction. The guiding elements allow the first part of each segment to move between the advanced position and the retracted position. In particular, each segment or the first part of each segment is mounted between two of the guiding elements. The two guiding elements guide the movement of the corresponding segment or first part of the segment in the movement direction. Preferably, the guiding elements are rails or guide rails.

In a further refinement of any one of the above aspects, the frame may be configured to restrict the movement of each segment or the movement of the first part of each segment between the advanced position and the retracted position.

By restricting the movement between the advanced position and the retracted position, it can be avoided that the segments or the first parts of the segments can be removed from or fall out of the frame. Thereby, safety of the segment is increased.

In a further refinement of any one of the above aspects, the guiding elements may comprise mechanical stops for restricting the movement of each segment or the movement of the first part of each segment between the advanced position and the retracted position.

With other words, for each segment, at least one mechanical stop is provided by the guiding elements for stopping the segment (or the first part of the segment) at the advanced position and the retracted position. Each segment or the first part of each segment may comprise, for each mechanical stop, a first element and a second element separated in the movement direction, wherein the mechanical stop is in contact with the first element in the advanced position and in contact with the second element in the retracted position. Each mechanical stop extends perpendicular to the movement direction toward the respective segment and the first and second elements extend perpendicular to the movement direction toward the respective guiding element. In the case that each segment (or the first part of segment) is guided by two guiding elements, only one of the two guiding elements may comprise the mechanical stop. Alternatively, both guiding elements may comprise a mechanical stop. In this case, each segment comprises a first element and a second element for each mechanical stop.

In a further refinement of any one of the above aspects, each guiding element may comprise one or more floating bearings for mounting the corresponding segment or the first part of the segment in a floating manner.

As described above, the floating bearings can be flexible elements such as flexible spacers, lances, and the like. Preferably, lances are used as the floating bearings. The floating bearings can be formed by or mounted on the guiding elements. In particular, the floating bearings are arranged between the guiding elements and each segment or between the guiding elements and the first part of the segment. By this configuration, the guiding elements guide the movement of the segments in the movement direction and also allow the segments to float within the frame. Thereby, the mechanical stability is further improved.

In a further refinement of any one of the above aspects, the first part of each segment may be lockable in the advanced position, in particular wherein the first part of each segment is lockable in the retracted position.

In particular, the guiding elements and the segments may comprise a locking mechanism by which each segment or the first part of each segment can be locked in the respective position. Thereby, the first part of the segment can be secured in the respective position.

In a further refinement of any one of the above aspects, each segment may comprise one or more levers, wherein the guiding elements comprise, for each lever, a first hole and a second hole, wherein the lever is engageable with the corresponding first hole for locking the first part of the segment in the advanced position, wherein the lever is engageable with the corresponding second hole for locking the first part of the segment in the retracted position.

The first hole corresponds to the advanced position. The second hole corresponds to the retracted position. When the lever is engaged with one of the holes, the segment is locked in the corresponding position. Thus, by the levers and the corresponding holes, each segment can be secured in the respective positions. When only the first part of each segment is movable, the lever is arranged on the first part of the segment. When each segment is movable, the lever is arranged on the segment, preferably on the second part of the segment. The lever can be rotatably mounted on the segment, in particular on the first part or the second part of the segment. When the first part of the segment is arranged in the advanced or in the retracted position, the lever can be engaged with the respective hole by rotating the lever. In particular, one end of the lever can be inserted into the respective hole by rotating the lever. In particular, the lever may have a handle by which the segment or the first part of the segment can be moved by a user parallel to the movement direction. By the lever, handling of the segment, in particular, movement and/or locking of the segment, is facilitated.

In a further refinement of any one of the above aspects, the guiding elements comprise a first portion and a second portion, wherein the first portion is attachable to the OD chassis, wherein the second portion is flexibly connected to the first portion, wherein the first and second holes are arranged in the second portions of the guide rails.

By the flexible connection of the first portion and the second portion, the segment (or the first part of the segment) still has some mechanical slackness even when the first part of the segment is locked in one of the advanced or the retracted position. For instance, the first portion can be connected to the second portion via an elastic portion. In particular, the first portion of the guiding elements can be fixedly connected with a side wall of the housing of the OD chassis. The floating bearings can be arranged at the first portion of the guiding elements.

In a further refinement of any one of the above aspects, the sled may comprise one or more electronic components, wherein the connection elements are connected to the one or more electronic components via cables.

The cables may be flexible wires. The cables may be electrical cables or optical cables. The electronic components may be processor units, fabric chips, and/or utilities. The electronic components can be mounted on one or more of the segments or can be fixedly mounted to the frame. When the first part of the segment moves, the cable connection between the connection elements and the electronic components secures the connections therebetween. In particular, when connections are to be established between connection elements and electronic components located at different parts of the sled that can move relative to another, the cable connection provides a simple and secure way for establishing the connection therebetween. Further, cables reduce or eliminate the need for expensive active devices like retimers and high performance board materials. For instance, when the sled is a fabric sled that comprises at least one fabric chip, the fabric chip or chips can be connected via cables to several connection elements of the sled, in particular when connection elements are arranged such that they are movable relative to the fabric chip. In particular, when the fabric sled comprises two or more segments, connection elements of each segment can be connected via the cable connection to the fabric sled, regardless where the fabric chip is arranged in the sled (at one of the segments or fixedly connected to the frame). Alternatively, the connection elements of the sled could also be directly connected to each other by using cables.

In a further refinement of the second aspect above, each horizontal sled may comprise a plurality of first connection elements, wherein each vertical sled may comprise a plurality of second connection elements, and wherein the first connection elements and the second connection elements are connectable to each other to establish the OD connection.

By the OD connection, each horizontal sled is connected to all vertical sleds. Therefore, the first connecting elements of a horizontal sled are connected to corresponding second connection elements of different vertical sleds. The first connection elements preferably are sockets and the second connection elements preferably are plugs. The sockets and plugs have mating shape.

In a further refinement of the third aspect above, in the step of arranging each segment, each segment may be locked in the retracted position, wherein the method may further comprise the following steps:
- before the step of moving each segment, unlocking each segment of the sled from the retracted position; and
- after the step of moving each segment, locking each segment in the advanced position.

The unlocking and locking steps may be performed after inserting the sled into the OD chassis. By locking the segments of the sled in the respective position before and after insertion of the sled, the segments are secured in the respective position so that they cannot move unintentionally out of position. For instance, the at least one lever of each segment of the sled can initially (in the step of arranging) be engaged with the respective second hole of the corresponding guiding element so that each segment is locked in the retracted position. Then, the lever of each segment can be released (disengaged) from the second hole to unlock each segment from the retracted position. Then, the lever of each segment can be moved or pushed for moving each segment from the retracted position to the advanced position. Then, the lever of each segment can be engaged with the respective first hole of the corresponding guiding element to lock each segment in the advanced position.

In a further refinement of the fourth aspect above, the method may further comprise the following steps:
- before the step of moving each segment, unlocking each segment of the sled from the advanced position; and
- after the step of moving each segment, locking each segment in the retracted position.

The unlocking and locking steps may be performed before removing the sled from the OD chassis. By locking the segments of the sled in the respective position before and after removal of the sled, the segments are secured in the respective position so that they cannot move unintentionally out of position. For instance, at least one lever of each segment of the sled can initially be engaged with the respective first hole of the corresponding guiding element so that each segment is locked in the advanced position. Then, the lever of each segment can be released (disengaged) from the first hole to unlock each segment from the advanced position. Then, the lever of each segment can be moved or pushed for moving each segment from the advanced position to the retracted position. Then, the lever of each segment can be engaged with the respective second hole of the corresponding guiding element to lock each segment in the retracted position.

In a further refinement of the sixth aspect above, in the step of arranging each segment, each segment may be locked in the retracted position, wherein the method may further comprise the following steps:
- before the step of moving each segment, unlocking each segment of the one or more other sleds from the retracted position; and
- after the step of moving each segment, locking each segment of the one or more other sleds in the advanced position.

The unlocking and locking steps may be performed after inserting the sled into the OD chassis. By locking the segments of the one or more other sleds in the respective position before and after insertion of the sled, the segments are secured in the respective position so that they cannot move unintentionally out of position. For instance, the at least one lever of each segment of the one or more other sleds can initially (in the step of arranging) be engaged with the respective second hole of the corresponding guiding element so that the segment is locked in the retracted position. Then, the lever of each segment can be released (disengaged) from the second hole to unlock each segment from the retracted position. Then, the lever of each segment can be moved or pushed for moving each segment from the retracted position to the advanced position. Then, the lever of each segment can be engaged with the respective first hole of the corresponding guiding element to lock each segment in the advanced position.

In a further refinement of the seventh aspect above, the method may further comprise the following steps:
- before the step of moving each segment, unlocking each segment of the one or more other sleds from the advanced position; and
- after the step of moving each segment, locking each segment of the one or more other sleds in the retracted position.

The unlocking and locking steps may be performed before removing the sled from the OD chassis. By locking the segments of the one or more other sleds in the respective position before and after removal of the sled, the segments are secured in the respective position so that they cannot move unintentionally out of position. For instance, at least one lever of each segment of the one or more other sleds can initially be engaged with the respective first hole of the corresponding guiding element so that each segment is locked in the advanced position. Then, the lever of each segment can be released (disengaged) from the first hole to unlock each segment from the advanced position. Then, the lever of each segment can be moved or pushed for moving each segment from the advanced position to the retracted position. Then, the lever of each segment can be engaged with the respective second hole of the corresponding guiding element to lock each segment in the retracted position.

In a further refinement of the ninth aspect above, the segmented sled may comprise one or more electronic component, wherein the method may further comprise the following steps:
- providing one or more electronic components;
- arranging the one or more electronic components within the frame; and
- connecting the connection elements to the one or more electronic components via cables.

In the step of arranging the one or more components, the one or more electronic components can be fixedly mounted to the frame, to one or more segments or to the second part of one or more segments. The cables may be flexible wires. The cables may be electrical cables or optical cables. The electronic components may be processor units, fabric chips, and/or utilities. The electronic components can be mounted on one or more of the segments or can be fixedly mounted to the frame. When the first part of the segment moves, the cable connection between the connection elements and the electronic components secures the connections therebetween. In particular, when connections are to be established between connection elements and electronic components located at different parts of the sled that can move relative to another, the cable connection provides a simple and secure way for establishing the connection therebetween. Further, cables reduce or eliminate the need for expensive active devices like retimers and high performance board materials. For instance, when the sled is a fabric sled that comprises at least one fabric chip, the fabric chip or chips can be connected via cables to several connection elements of the sled, in particular when connection elements are arranged such that they are movable relative to the fabric chip. In particular, when the fabric sled comprises two or more segments, connection elements of each segment can be connected via the cable connection to the fabric sled regardless where the fabric chip is arranged in the sled (at one of the segments or fixedly connected to the frame). Alternatively, the connection elements of the sled could also be directly connected to each other by using cables.

It goes without saying that the features mentioned above and those yet to be explained below cannot only be used in the respective combinations disclosed, but also in different combinations or alone without departing from the scope of the present invention.

### Brief description of the drawings

Further features and advantages will be apparent from the following detailed description. Unless otherwise defined, all technical and scientific terms have the meaning as commonly understood by one of ordinary skill in the art. In the drawings:
- Fig. 1: shows a simplified schematic illustration of an exemplary embodiment of a sled;
- Fig. 2: shows a simplified schematic illustration of a side view of a segment of the sled of Fig. 1 arranged in an advanced position;
- Fig. 3: shows a simplified schematic illustration of a rear view of the segment of Fig. 2;
- Fig. 4: shows a simplified schematic illustration of a side view of the segment of Fig. 2 arranged between the advanced position and a retracted position;
- Fig. 5: shows a simplified schematic illustration of a side view of the segment of Fig. 2 arranged in the retracted position;
- Fig. 6: shows the illustration of the segment of Fig. 2 including a fan unit;
- Fig. 7: shows the illustration of the segment of Fig. 3 including a fan unit;
- Fig. 8: shows a simplified schematic illustration of a second exemplary embodiment of the sled;
- Fig. 9: shows an isometric illustration of a third exemplary embodiment of a the sled;
- Fig. 10: shows a plan view of the sled of Fig. 9;
- Fig. 11: shows an isometric illustration of a fourth exemplary embodiment of the sled;
- Fig. 12: shows a simplified schematic illustration of a first exemplary embodiment of an OD chassis;
- Fig. 13: shows an isometric illustration of a rear side of a second exemplary embodiment of an OD chassis;
- Fig. 14: shows an isometric illustration of a front side of the OD chassis of Fig. 13;
- Fig. 15: shows a flow diagram of an exemplary embodiment of a method for inserting a sled in an OD chassis;
- Fig. 16: shows a flow diagram of an exemplary embodiment of a method for removing a sled from an OD chassis;
- Fig. 17: shows a flow diagram of an exemplary embodiment of a method for replacing a sled in an OD chassis;
- Fig. 18: shows a flow diagram of an exemplary embodiment of a method for inserting a sled in an OD chassis;
- Fig. 19: shows a flow diagram of an exemplary embodiment of a method for removing a sled from an OD chassis;
- Fig. 20: shows a flow diagram of an exemplary embodiment of a method for replacing a sled in an OD chassis; and
- Fig. 21: shows a flow diagram of an exemplary embodiment of a method for assembling a sled for an orthogonal-direct, OD, chassis.

### Detailed description of the drawings

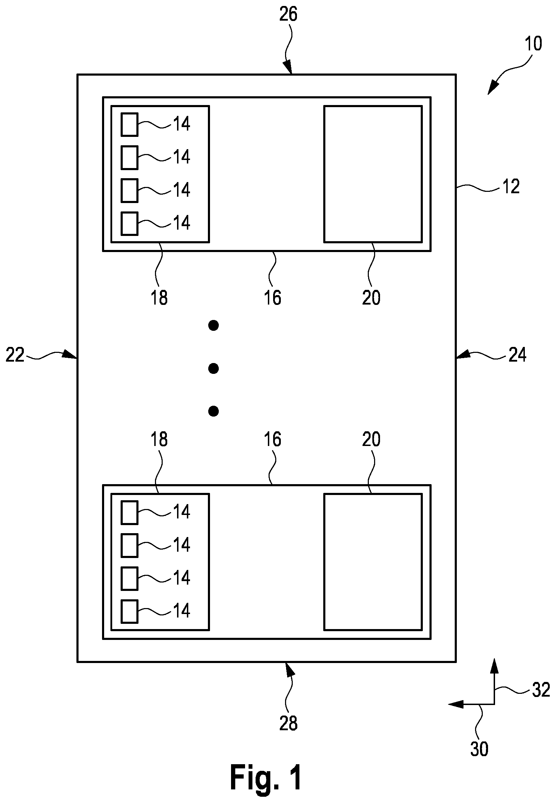

In Fig. 1, a first exemplary embodiment of the new sled is shown designated by reference number 10 in its entirety. The sled 10 can serve as a sled for an OD chassis. In particular, the sled 10 can be inserted into a respective slot of the OD chassis. The sled 10 can be used as a horizontal sled or a vertical sled of the OD chassis. The sled 10 can be a processor sled, a fabric sled, or a utility sled. Preferably, the sled 10 is a fabric sled or a utility sled.

The sled 10 comprises a frame 12, a plurality of connection elements 14, and one or more segments 16. In particular, the sled 10 can comprise a plurality of segments 16. Each segment 16 is arranged within the frame 12. In particular, each segment 16 is mounted to frame 12. Each segment 16 comprises a first part 18. Each segment may further comprise a second part 20. One or more of the connection elements 14 are mounted to the first part 18 of each segment 16.

The connection elements 14 are configured to establish an OD connection with one or more other sleds of the OD chassis when the sled 10 is inserted in the OD chassis. In particular, the connection elements can connect with corresponding connection elements of the one or more other sleds of the OD chassis to establish the OD connection. For the OD connection, always one connection element of the one or more other sleds connects with one connection element 14 of the sled 10.

The sled 10 comprises a first side 22, a second side 24, a third side 26, a fourth side 28, a fifth side and a sixth side (not depicted in Fig. 1). The first side 22 and the second side 24 are opposite to each other in a first direction 30. The first direction 30 extends from the first side 22 to the second side 24. The third side 26 and the fourth side 28 are opposite to each other in a second direction 32. The fifth side and a sixth side are opposite to each other in a third direction. The first direction 30, the second direction 32 and the third direction may be perpendicular to each other. In particular, the first direction 30, the second direction 32 and the third direction may form a cartesian coordinate system.

Each segment 16 extends in the first direction 30 and the second direction 32. The segments 16 can be consecutively arranged in the second direction 32. Adjacent segments 16 may be spaced apart in the second direction 32. The first part 18 of each segment 16 is arranged at the first side 22 of the sled 10. In particular, the connection elements 14 are arranged at the first side 22 of the sled 10. The second part 20 of each segment 16 can be arranged between the first part 18 of the segment 16 and the second side 24 of the sled 10.

The frame 12 may cover at least the third side 26, the fourth side 28, the fifth side and the sixth side of the sled 10. The frame 12 comprises a first opening at the first side 22. The frame 12 may further comprise a second opening at the second side 24. The connection elements 14 mounted on the first part 18 of each segment 16 are accessible from the first side 22 through the first opening. In particular, the connection elements 14 may protrude out of the first opening on the first side 22.

At least the first part 18 of each segment 16 is movable relative to the frame 12. For instance, the first part 18 of each segment 16 can be movably mounted to the frame 12. Alternatively, each segment 16 can be movably mounted to the frame 12. Alternatively, the second part 20 of each segment 16 can be fixedly mounted to the frame and the first part 18 of each segment 16 can be movably mounted to the respective second part 20 of the segment 16.

Each segment 16 or the first part 18 of each segment 16 can be mounted in a floating manner within the frame 12. For instance, the frame 12 or each segment 16 can comprise one or more floating bearings for mounting each segment 16 or the first part 18 of each segment 16 in a floating manner. For instance, the frame 12 or each segment 16 can comprise a plurality of lances as the floating bearings. In particular, the lances can be arranged at opposite sides of each segment 16 or the first part 18 of each segment 16, wherein the opposite sides are opposite to each other in the second direction 32. Thereby, each segment 16 or the first part 18 of each segment 16 is mounted between corresponding lances at the opposite sides in a floating manner.

Further, each segment 16 or the first part 18 of each segment 16 may be movable parallel to a movement direction. In particular, the movement direction is parallel to the first direction. In the movement direction, the first part of each segment 16 can be moved between an advanced position and a retracted position. In the advanced position, the first part 18 of the segment 16 is arranged closer to the first side than in the retracted position. The OD connection can be established when the first part 18 of each segment 20 is arranged in the advanced position. The first part 18 of each segment 16 may be lockable in the advanced position and the retracted position, respectively.

The sled may further comprise a plurality of fan units. One or more of the fan units can be mounted to each segment 16. The fan units can be mounted to the first part 18 or the second part 20 of the respective segment 16. The fan units can be arranged at a side of the segment 16 facing the rear side 24 of the sled 10. In particular, the fan units can be arranged at the second opening at the rear side 24 of the sled 10.

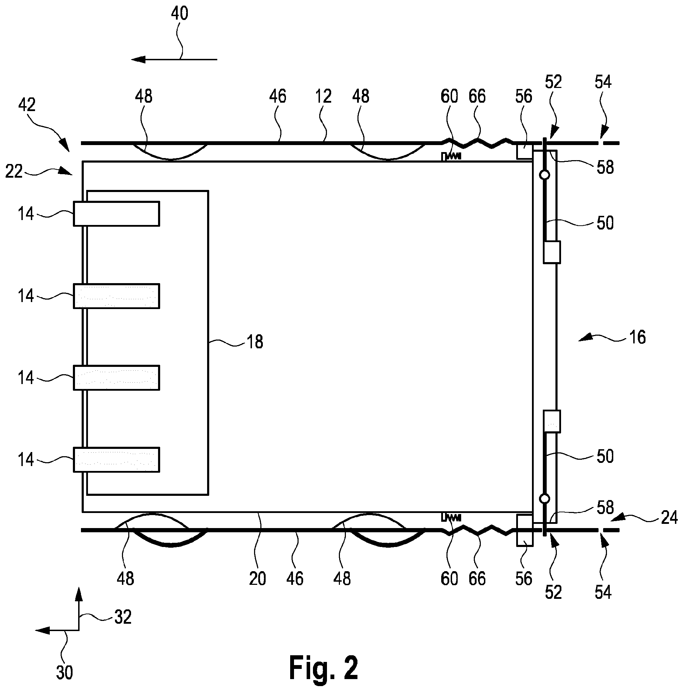

Figures 2 to 5 shows an exemplary configuration of one segment 16 of the sled 10 and, more particularly, how this segment 16 is mounted within the frame 12. Each segment 16 of the sled 10 can be mounted in the same way as the segment 16 shown in Figures 2 to 5.

The first part 18 of the segment 16 is fixedly mounted to the second part 20 of the segment 16. The first part 18 may be a segment board and the second part 20 may be a segment housing. The segment 16 is mounted to the frame 12 in such a way that the segment 16 is movable relative to the frame 12 in a movement direction 40. The movement direction is parallel to the first direction 30. In this way, the first part 18 of the segment 16 is movable relative to the frame 12 in the movement direction 40. In particular, the first part 18 is movable in the movement direction 40 between an advanced position 42 and a retracted position.

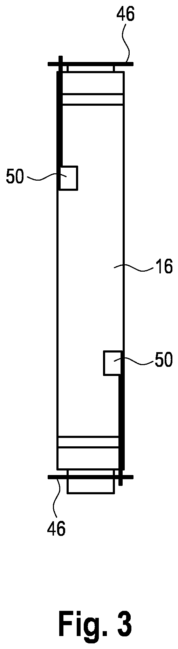

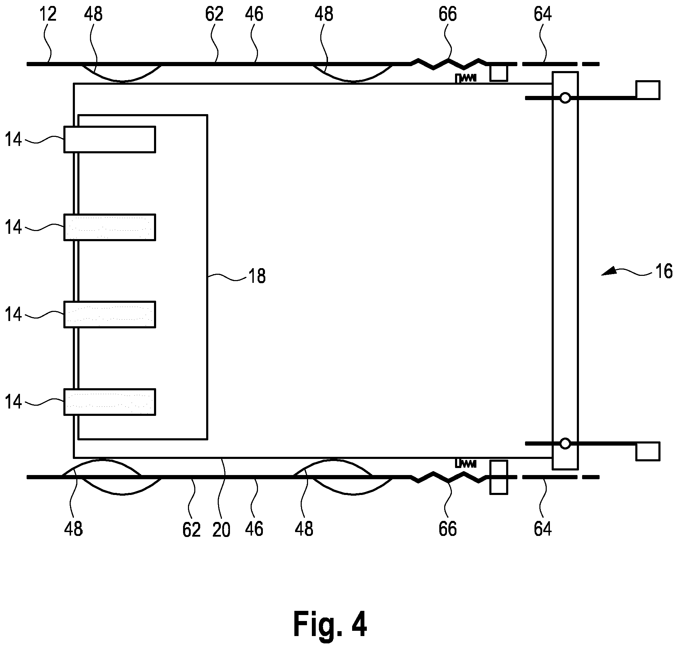

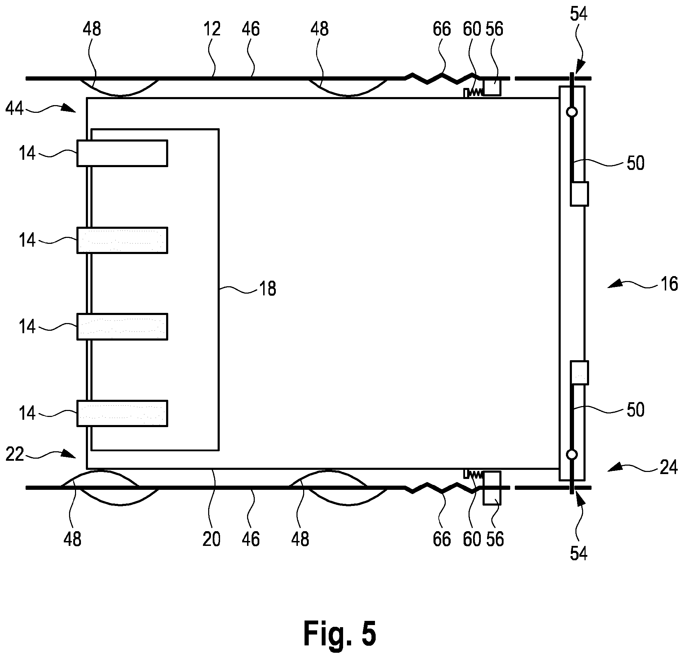

In Figures 2 and 3, the first part 18 is arranged in the advanced position 42. In Fig. 5, the first part 18 is arranged in the retracted position 44. In Fig. 4, the first part 18 is arranged between the advanced position 42 and the retracted position 44. In the advanced position 42, the connection elements 14 protrude out of the first opening of the frame 12 at the first side 22. In the retracted position 44, the connection elements 14 are retracted into the frame 12 so that they do not protrude out of the first opening of the frame 12 at the first side 22. Only when the first part 18 is arranged in the advanced position, the connection elements 14 are enabled to establish the OD connection.

The frame 12 comprises two guiding elements 46 for mounting the segment 16 within the frame 12. The guiding elements 46 may be guiding rails. The guiding elements 46 extend in the first direction 30. Thus, the guiding elements 46 also extend in the movement direction 40. The two guiding elements 46 are configured to guide the movement of the segment 16 in the movement direction 40. The guiding elements 46 are spaced apart from each other in the second direction 32. In the second direction, the guiding elements 46 are arranged at opposite sides of the segment 16.

Each guiding element 46 may comprise two lances 48 for mounting the segment 16. The lances 48 serve as floating bearings for mounting the segment in a floating manner. The two lances 48 of each guiding element 46 are spaced apart in the first direction 30. The lances 48 extend from each guiding element toward the segment 16.

The first part 18 is lockable in the advanced position 42. The first part 18 is also lockable in the retracted position 44. The segment 16 comprises two levers 50. The levers 50 are rotatably mounted on the second part 20. In particular, the levers 50 are arranged at an end of the second part 20 facing the second side 24. The levers 50 are accessible through the second opening at the second side 24. Each lever 50 is arranged adjacent to one of the guiding elements 46. For the two levers 50, each guiding element 46 comprises a first hole 52 and a second hole 54. Each lever 50 is engageable with the corresponding first hole 52 for locking the first part 18 of the segment 16 in the advanced position 42. Each lever 50 is also engageable with the corresponding second hole 54 for locking the first part 18 of the segment 16 in the retracted position 44. The lever 50 may have a handle. A user can use the handle to rotate the lever 50 for engaging or disengaging the lever 50 with one of the holes 52, 54. A user can also use the handle to push or pull the lever 50 in the movement direction 40. Thereby, the segment 16 can be moved parallel to the movement direction 40.

Each guiding element 46 comprises a stopper 56 for stopping the movement of the segment 16. On each side of the segment 16 facing one of the guiding elements 46, the segment 16 comprises a first element 58 and a second element 60. The first element 58 and the second element 60 are spaced apart from each other in the first direction 30. Each stopper 56 is arranged between the first element 58 and the second element 60 of the corresponding guiding element 46. In the advanced position 42, the stopper 56 is in contact with the first element 58. In the retracted position 44, the stopper 56 is in contact with the second element 60. Thus, by the stopper 56, the first element 58, and the second element 60, the movement of the segment 16, in particular the movement of the first part 18 of the segment 16, is restricted between the advanced position 42 and the retracted position 44.

Each guiding element 46 comprises a first portion 62 and a second portion 64. The first portion 62 and the second portion 64 are flexibly connected to each other. In particular, the first portion 62 and the second portion 64 can be connected via an elastic portion 66. At the first portion 62, the two lances 46 are arranged. At the second portion 64, the holes 52, 54 and the stopper 56 are arranged.

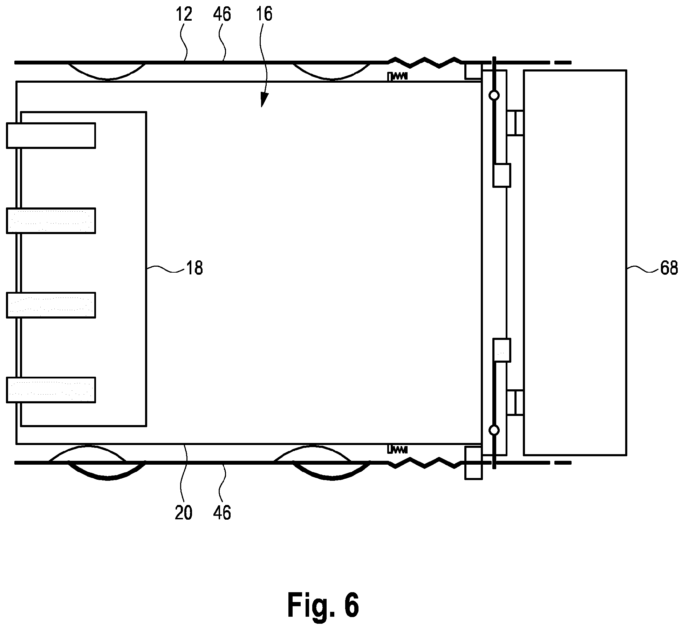

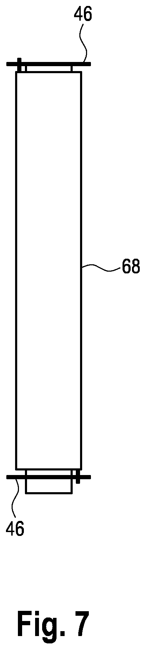

Figures 6 and 7 show the segment 16 of Figures 2 to 5, wherein the segment further comprises a fan unit 68. The fan unit 68 is arranged at a side of the segment facing the second side 24. Each segment 16 of the sled 10 can comprise such a fan unit 68. The fan unit 68 is attachable to and detachable from the second part 20 of the segment 16. For instance, when the first part 18 of the segment 16 is arranged in the advanced position 42, the fan unit 68 can be attached to the segment 16. When the first part 18 of the segment 16 shall be moved between the advanced position 42 and the retracted position 44, the fan unit can be detached from the segment 16.

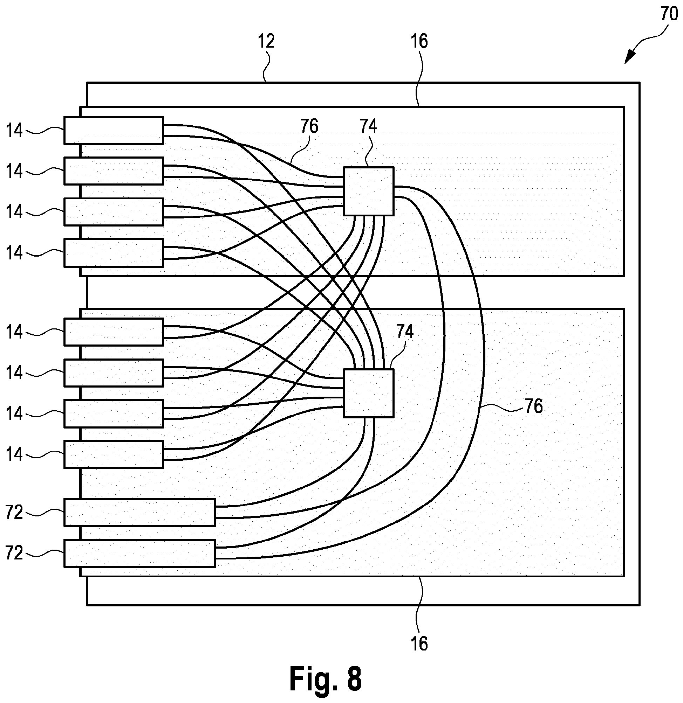

In Fig. 8, a second exemplary embodiment of the new sled is shown designated by reference number 70 in its entirety. The configuration of the sled 70 of the second exemplary embodiment is substantially the same as the configurations of the sled 10 of the first exemplary embodiments. In particular, the segments 16 of the sled 70 are mounted to within the frame 12 in the same way as the segments 16 in the sled 10. The same elements are designated with the same reference numerals and are not described in more detail.

The sled 70 comprises eight connection elements 14 for establishing the OD connection. The sled 70 comprises two segments 16. Four of the connection elements 14 are mounted to each segment 16.

The sled 70 additionally comprises one or more further connection elements 72. The connection elements 72 can be used to provide utilities to the sled such as power or data exchange with external components (for example network connection or management). In Fig. 8, two further connection elements 72 are depicted that are mounted to one of the segments 16 (the lower one). For instance, one of the connection elements 72 can be used to provide power to the sled 70, wherein the other can be used for data exchange with external components, in particular for management of the sled 70.

The sled 70 comprises two electronic components 74. The electronic components 74 may be a fabric chip, a processor unit, or utilities. Each electronic component 74 is mounted to one of the segments 16.

The connection elements 14, 72 are connected to the electronic components via cables 76. In particular, each of the connection elements 14, 72 is connected to each electronic component 74 via a corresponding cable 76. The cables 76 may be electrical cables or optical cables.

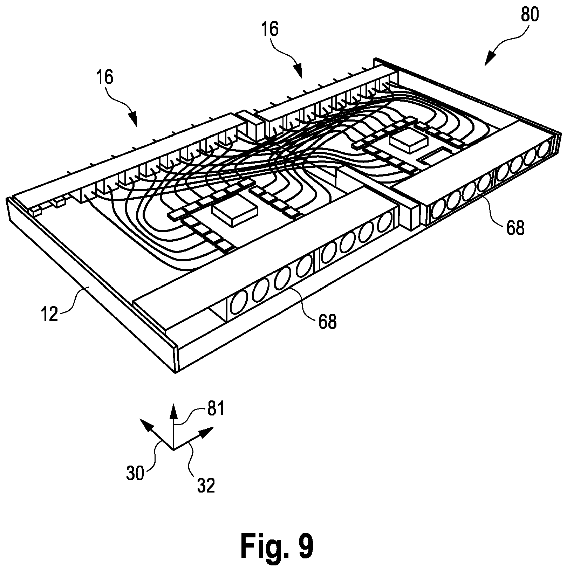

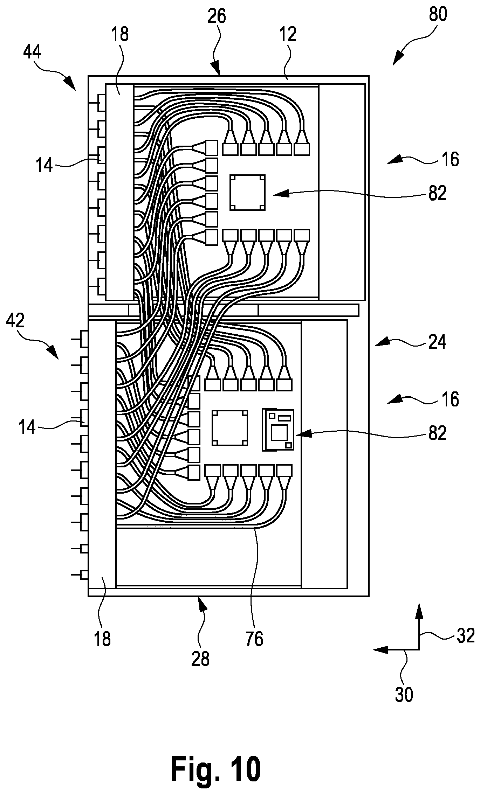

In Figs. 9 and 10, a third exemplary embodiment of the new sled is shown designated by reference number 80 in its entirety. The configuration of the sled 80 of the third exemplary embodiment is substantially the same as the configurations of the sleds 10 and 70 of the first and the second exemplary embodiment. In particular, the segments 16 of the sled 80 are mounted to within the frame 12 in the same way as the segments 16 in the sled 10 (see Figs. 1 to 7). The same elements are designated with the same reference numerals and are not described in more detail.

In Figs. 9 and 10, the cover of the frame 12 at the fifth side of the sled 80 is removed for illustrative purposes. The third direction in which the fifth side and the sixth side are opposite to each other is designated by reference number 81. The sled 80 comprises two segments 16. The first part 18 of one segment 16 (in particular the one arranged adjacent to the third side 26) is arranged in the retracted position 44 and the first part of the other segment 16 (in particular the one arranged adjacent to the fourth side 28) is arranged in the advanced position 42.

Eight connection elements 14 are mounted to the first part 18 of each segment 16. In addition, two further connection elements 72 are mounted to one of the segments 72, in particular to the one arranged adjacent to the fourth side 28.

The sled comprises two fabric chips 82. Each fabric chip is mounted to one of the segments 16. Each fabric chip 82 is mounted to the second part 20 of the corresponding segment 16. The connection elements 14, 72 are connected to the fabric chips 82 via cables 76. In particular, each of the connection elements 14, 72 is connected to each fabric chip 82 via a corresponding cable 76. The cables 76 may be electrical cables or optical cables.

Each segment 16 comprises a fan unit 68. The fan unit 68 is arranged at a side of the segment facing the second side 24 of the sled 80.

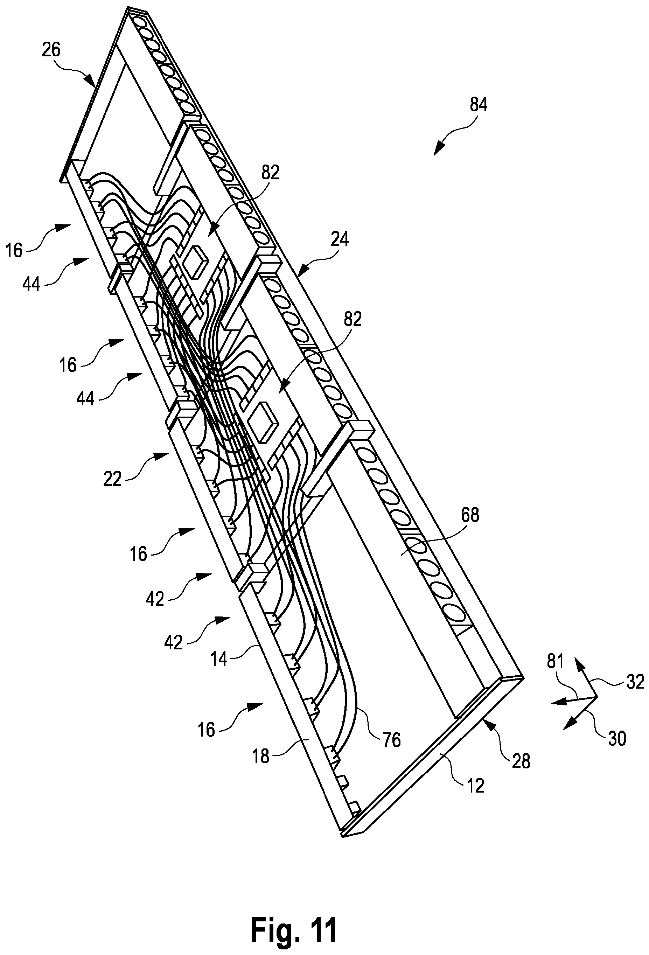

In Fig. 11, a fourth exemplary embodiment of the new sled is shown designated by reference number 84 in its entirety. The configuration of the sled 84 of the fourth exemplary embodiment is substantially the same as the configurations of the sleds 10, 70 and 80 of the first to third exemplary embodiments. In particular, the segments 16 of the sled 84 are mounted to the frame 12 in the same way as the segments 16 of the sled 10. The same elements are designated with the same reference numerals and are not described in more detail.

In Fig. 11, the cover of the frame 12 at the fifth side of the sled 84 is removed for illustrative purposes. The sled 84 comprises four segments 16. The first parts 18 of two segments 16 (in particular the ones that are arranged closest to the third side 26) are arranged in the retracted position 44 and the first parts 18 of the other two segments 16 (in particular the ones that are arranged closest to the fourth side 28) are arranged in the advanced position 42.

Four connection elements 14 are mounted to the first part 18 of each segment 16. In addition, two further connection elements 72 are mounted to one of the segments 72, in particular to the one arranged closest to the fourth side 28.

The sled 84 comprises two fabric chis 82. The fabric chips 82 are mounted to two of the segments 16. In particular, the two segments 16 to which the fabric chis 82 are mounted are arranged in the second direction 32 between the other two segments 16.

The connection elements 14, 72 are connected to the fabric chips 82 via cables 76. In particular, each of the connection elements 14, 72 is connected to each fabric chip 82 via a corresponding cable 76. The cables 76 may be electrical cables or optical cables.

Each segment 16 comprises a fan unit 68. The fan unit 68 is arranged at a side of the segment facing the second side 24 of the sled 84.

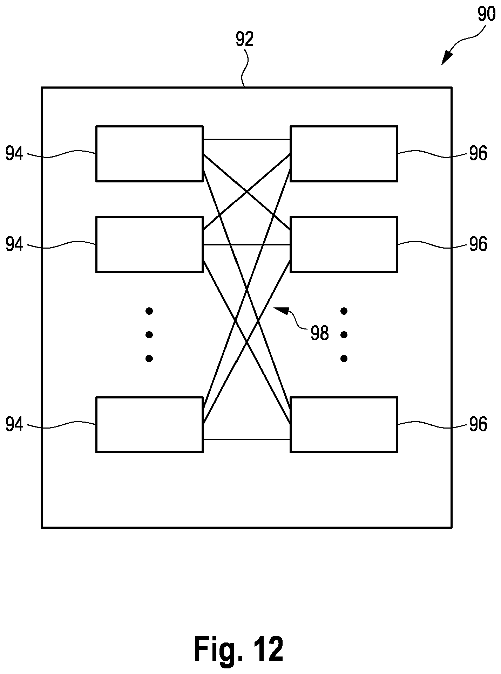

In Fig. 12, a first exemplary embodiment of the new OD chassis is shown designated by reference number 90 in its entirety.

The OD chassis 90 comprises a front side, a rear side, a left side, a right side, a top side, and a bottom side. The front side and the rear side arranged opposite to each other in a front-rear direction. The left side and the right side are arranged opposite to each other in a left-right direction. The top side and the bottom side are arranged opposite to each other in a top-bottom direction. The front-rear direction, the left-right direction and the top-bottom direction define a three-dimensional (3D) coordinate system, preferably a cartesian coordinate system. In particular, the front-rear direction, the left-right direction and the top-bottom direction are arranged perpendicular to each other. The top-bottom direction is vertically arranged. The front-rear direction and the left-right direction are horizontally arranged.

The OD chassis 90 comprises a housing 92. The housing 92 of the OD chassis 90 may comprise a number of slots in which sleds can be inserted. In particular, the slots are arranged at the front side and at the rear side of the OD chassis. The slots at the front side of the OD chassis extend in the left-right direction. Thus, the slots at the front side of the OD chassis extend in a horizontal direction. The slots at the rear side extend in the top-bottom direction. Thus, the slots at the rear side extend in a vertical direction.

The OD chassis 90 comprises one or more horizontal sleds 94 and one or more vertical sleds 96. The horizontal sleds 94 are inserted into the slots at the front side of the OD chassis 90. The horizontal sleds 94 are horizontally arranged in the OD chassis 100 when inserted. For instance, the OD chassis 100 can comprise four, eight, 16, or 32 horizontal sleds 102. The horizontal sleds 94 preferably are processor sleds. The vertical sleds 96 are inserted into the slots at the rear side of the OD chassis. The sleds 96 are vertically arranged in the OD chassis 90 when inserted. The vertical sleds 96 preferably are fabric sleds and/or utility sleds. In particular, the OD chassis 90 may comprise four, six, eight, 16, or 32 fabric sleds as vertical sleds 96. The number of fabric sleds may be equal to or less than the number of processor sleds. In addition, to the fabric sleds, at least one vertical sled 96 may also be a utility sled.

The horizontal sleds 94 are consecutively arranged in the top-bottom direction. Adjacent horizontal sleds 94 may be spaced apart in the top-bottom direction. The vertical sleds 96 are consecutively arranged in the left-right direction. Adjacent vertical sleds 96 may be spaced apart in the left-right direction.

In the OD chassis 90, each horizontal sled 94 is connectable to each vertical sled 96 using an OD connection 98. Each horizontal sled 94 comprises a plurality of first connection elements. Each vertical sled 96 comprises a plurality of second connection elements. The first connection elements and the second connection elements are connectable to each other to establish the OD connection 98.

Preferably, the sleds 10, 70, 80, 84 of the first to fourth exemplary embodiment are used as the vertical sleds 96. Additionally or alternatively, the sleds 10, 70, 80, 84 of the first to fourth exemplary embodiment may be used as the horizontal sleds 94.

For instance, the OD chassis 90 may comprise a number of processor sleds as the horizontal sleds 94 and a number of fabric sleds as the vertical sleds 96. Each processor sled may comprise a number of processors (processor units). Each fabric sled may comprise a number of fabric chips. The connection elements of the fabric sleds are plugs. The connection elements of the processor sleds are sockets. The height of the chassis is preferably a positive integer multiple of the standard rack unit size 1U where 1U equals 1,75 inches or 44,45 mm. Different configurations of various OD chassis are provided in Table 1 shown below.

**Table 1**

| | | Math | Alternative System Designs using the same processor chip and the same fabric chip | | | | | | | | | |
|---|---|---|---|---|---|---|---|---|---|---|---|---|
| A | # of processors in system | C*D | 8 | 8 | 16 | 32 | 64 | 48 | 32 | 32 | 16 | 16 |
| B | Height of system's chassis | ≥C*D | 5U | 5U | 9U | 18U | 36U | 36U | 36U | 36U | 36U | 32U |
| C | Processor-sled: # processors / height | | 2P / 1U | 2P / 1U | same | 2P / 1U | sled | 3P / 2U | 1P / 1U | 2P / 2U | 2P / 4U | 4*(2P / 6U) |
| D | Number of P-sleds | I*J | 4 | 4 | 8 | 16 | 32 | 16 | 32 | 16 | 8 | +4*(2P / 2U) |
| E | Bifurcation of processor fabric lanes | G*x? | 4x16 | 6x16 | 8x8 | 16x4 | 32x2 | *32x2* | 16x4 | 16x4 | 8x8 | 8x8 |
| P | PCle/CXL lanes per processor | | 4x16 | 2x16 | 4x16 | | | | | | | |
| Q | PCle/CXL lanes per system | A*P | 32x16 | 16x16 | 64x16 | 128x16 | 256x16 | 192x16 | 128x16 | 128x16 | 64x16 | 64x16 |
| | | | | | | | | | | | | |
| F | # of Fabric-sleds | | 4 | 6 | | | | | 8 | | | |
| G | # of fabric chips in system | H*F | 4 | 6 | 8 | 16 | 32 | 32 | 16 | 16 | 8 | 8 |
| H | # of fabric chips per F-sled | I*J | 1 | 1 | 1 | 2 | 4 | 4 | 2 | 2 | 1 | 1 |
| I | # of segments per F-sled | | 1 | 1 | 1 | 2 | 4 | 4 | 4 | 4 | 4 | 1*(seg 4 plugs) |
| J | # of fabric plugs per segment | | 4 | 4 | 8 | 8 | 8 | 4 | 8 | 4 | 2 | +4*(seg 1 plug ) |
| K | # of lanes per fabric plug (or C*E/F) | H*L | 2x16 | 2x16 | 2x8 | 4x4 | 8x2 | 12x2 | 2x4 | 4x4 | 2x8 | 2x8 |
| L | # of lanes per near-chip plug | | 2x16 | 2x16 | 2x8 | 2x4 | 2x2 | 3x2 | 1x4 | 2x4 | 2x8 | 2x8 |
| M | # of near-chip plugs per fabric chip | D | 4 | 4 | 8 | 16 | 32 | 16 | 32 | 16 | 8 | 8 |
| N | Bifurcation of fabric chip (or L*M) | A*x? | 8x16 | 8x16 | 16x8 | 32x4 | 64x2 | 48x2 | 32x4 | 32x4 | 16x8 | 16x8 |

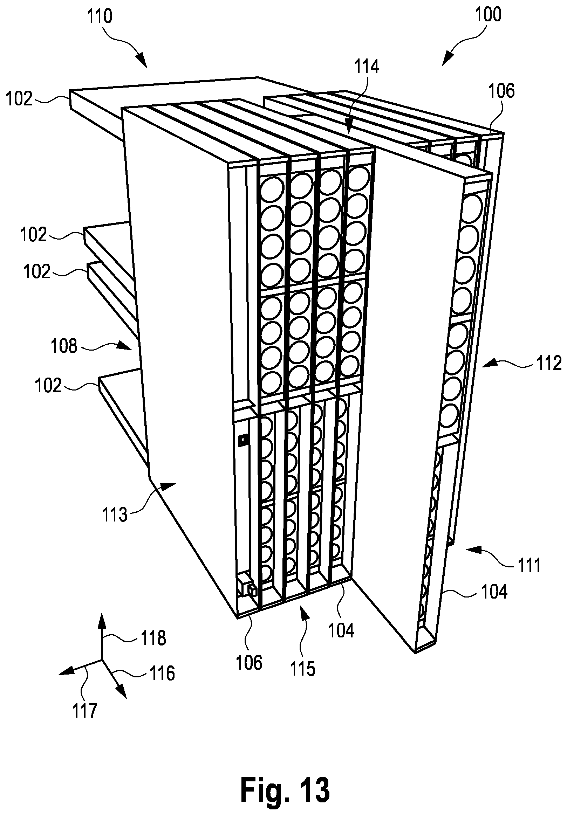

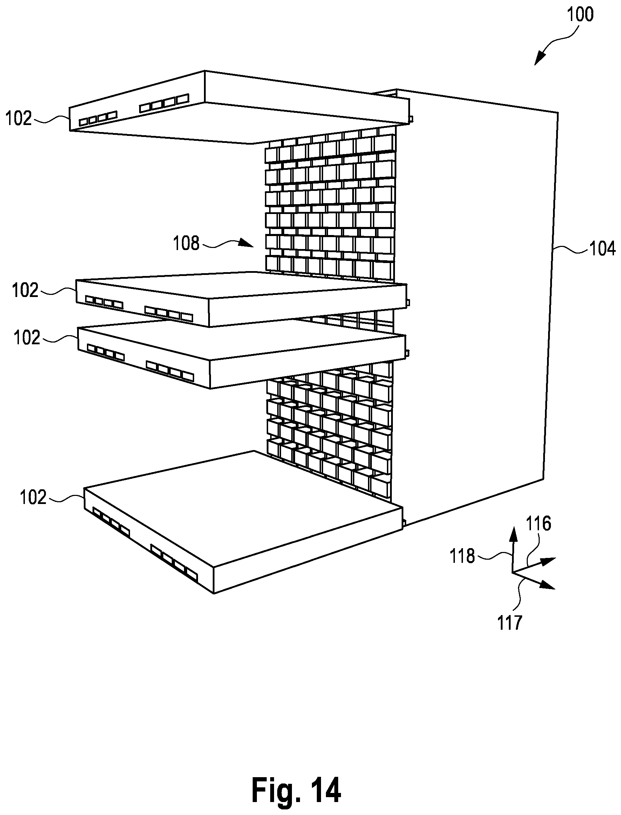

In Figs. 13 and 14, a second exemplary embodiment of the OD chassis is shown designated by reference number 100 in its entirety. The configuration of the OD chassis 100 of the fourth exemplary embodiment is substantially the same as the configurations of the OD chassis 90 of the first exemplary embodiment. The same elements are designated with the same reference numerals and are not described in more detail.

The OD chassis 100 comprises a front side 110, a rear side 111, a left side 112, a right side 113, a top side 114, and a bottom side 115. The front side 110 and the rear side 111 arranged opposite to each other in a front-rear direction 116. The left side 112 and the right side 113 are arranged opposite to each other in a left-right direction 117. The top side 114 and the bottom side 115 are arranged opposite to each other in a top-bottom direction 118. The front-rear direction 116, the left-right direction 117 and the top-bottom direction 118 define a three-dimensional (3D) coordinate system, preferably a cartesian coordinate system. In particular, the front-rear direction 116, the left-right direction 117 and the top-bottom direction 118 are arranged perpendicular to each other. The top-bottom direction 118 is vertically arranged. The front-rear direction 116 and the left-right direction 117 are horizontally arranged.

The OD chassis 100 may comprise a housing (not depicted). The housing has 16 slots at the front side 110 and ten slots at the rear side 111. The OD chassis 100 comprises 16 processor sleds 102 as horizontal sleds. The OD chassis 100 comprises eight fabric sleds 104 and two utility sleds 106 as vertical sleds. The processor sleds 102 are insertable into the slots at the front side 110. The fabric sleds 104 and the utility sleds 106 are insertable into the slots at the rear side 111.

The processor sleds 102 are consecutively arranged in the top-bottom direction 118. The fabric sleds 104 are consecutively arranged in the left-right direction 117. The fabric sleds 104 are arranged between the utility sleds 106 in the left-right direction 117.

When inserted, the processor sleds 102 can establish an OD connection 108 with the fabric sleds 104 and the utility sleds 106. Each processor sled 102 is connectable to each fabric sled 104 and each utility sled 106 via the OD connection 108. Each processor sled 102 comprises a plurality of first connection elements. Each vertical sled 104, 106 comprises a plurality of second connection elements. The first connection elements and the second connection elements are connectable to each other to establish the OD connection. In particular, the first connection elements of each processor sled 102 can connect with corresponding second connection elements of each vertical sleds 104, 106 to establish the OD connection 108. Thus, each first connection element of a processor sled 102 is connected to a corresponding second connection element of a different vertical sled 104, 106. The first connection elements of the processor sleds 102 are sockets. The second connection elements of the vertical sleds 104, 106 are plugs. The sockets and plugs have mating shape.

In the Figs. 13 and 14, only four processor sleds 102 are depicted at the front side of the OD chassis 100. The slots of the other (twelve) horizontal sleds are left empty for illustrative purposes. In each of the empty slots a processor sled 102 can be inserted. In Fig. 13, one of the fabric sleds 104 is only partially inserted into the OD chassis 100 in order to illustrate how the sleds can be inserted into the slots. In Fig. 14, among the vertical sleds, only the eight fabric sleds 104 are depicted. The respective slots for the two utility sleds 106 at the left side and the right side are left empty for illustrative purposes.

In general, the processor sleds 102 and/or the fabric sleds 104 and/or the utility sleds 106 can be configured as the sleds 10, 70, 80, 84 of the first to fourth embodiment shown in combination with the Figures 1 to 11. Preferably, only the vertical sleds (the fabric sleds 104 and the utility sleds 106) are configured as the sleds 10, 70, 80, 84 of the first to fourth embodiment. In particular, the sleds 80 or 84 of the third and fourth embodiment can be used as fabric sleds 104 in the OD chassis 100.

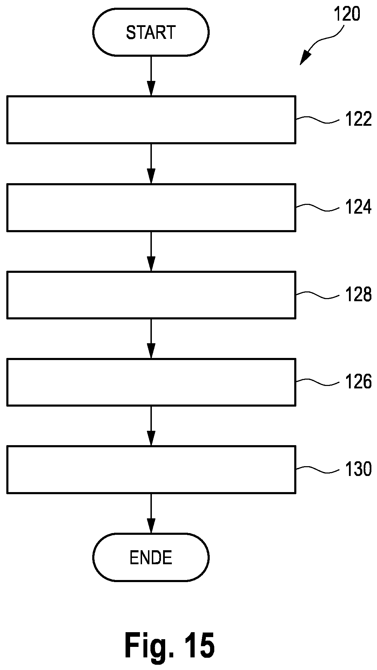

Fig. 15 shows a flow diagram for explaining an exemplary embodiment of a method for inserting a sled in an OD chassis designated by reference number 120 in its entirety. The sled that is inserted with the method 120 can be configured according to the sled of any of the first to fourth exemplary embodiments shown in Figs. 1 to 11. The method 120 can be used to insert the sled into an empty slot of the OD chassis of the first or second embodiment shown in Figs. 12 to 14. In particular, the first part 18 of each segment 16 of the sled is movable parallel to the movement direction 40 between the advanced position 42 and the retracted position 44. The sled establishes an OD connection with one or more other sleds of the OD chassis when the sled is inserted in the OD chassis. Preferably, the sled which is inserted is a vertical sled of the OD chassis, and the one or more other sleds are horizontal sleds of the OD chassis.

In a first step 122 of the method 120, the first part 18 of each segment 16 of the sled is arranged in the retracted position 44.

In a further step 124 of the method 120, the sled is inserted into the OD chassis. In particular, the sled is inserted in the respective empty slot of the OD chassis.

In a further step 126 of the method 120, the first part 18 of each segment 16 of the sled is moved from the retracted position 44 to an advanced position 42, thereby establishing the OD connection with the one or more other sleds of the OD chassis. In particular, the levers 50 of each segment 16 can be moved or pushed for moving each segment 16 from the retracted position 44 to the advanced position 42.

Optionally, in the step 122, each segment 16 can be locked in the retracted position 44. Therefore, the at least one lever 50 of each segment 16 of the sled can initially be engaged with the respective second holes 54 of the corresponding guiding elements 46.

In a further optional step 128 of the method 120 before the step 126 and after the step 124, each segment 16 of the sled is unlocked from the retracted position 44. In particular, the levers 50 of each segment 16 can be released from the respective second holes 54 to unlock each segment 16 from the retracted position 44.

In a further optional step 130 of the method 120 after the step 128, each segment 16 is locked in the advanced position 42. In particular, the levers 50 of each segment 16 can be engaged with the respective first holes 52 of the corresponding guiding elements 46 to lock each segment 16 in the advanced position 42.

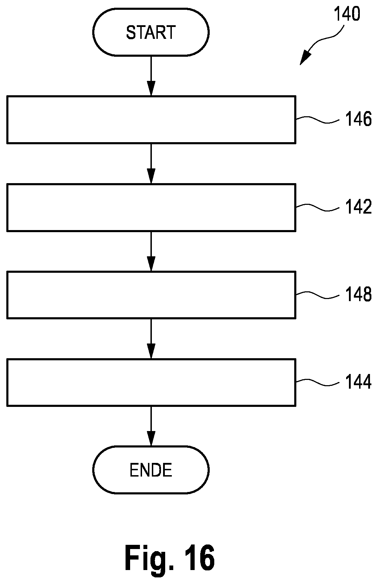

Fig. 16 shows a flow diagram for explaining an exemplary embodiment of a method for removing a sled from an OD chassis designated by reference number 140 in its entirety. The sled that is removed with the method 120 can be configured according to the sled of any of the first to fourth exemplary embodiments shown in Figs. 1 to 11. The method 120 can be used to remove the sled from a slot of the OD chassis of the first or second embodiment shown in Figs. 12 to 14. In particular, the first part 18 of each segment 16 of the sled is movable parallel to the movement direction 40 between the advanced position 42 and the retracted position 44. The sled establishes an OD connection with one or more other sleds of the OD chassis when the sled is inserted in the OD chassis. Preferably, the sled which is to be removed is a vertical sled of the OD chassis, and the one or more other sleds are horizontal sleds of the OD chassis. Initially, the sled is inserted in the OD chassis in the OD connection is established with the one or more other sleds of the OD chassis. In particular, the first part 18 of each segment 16 of the sled may be initially arranged in the advanced position 42.

In a first step 142 of the method 140, the first part 18 of each segment 16 of the sled is moved from the advanced position 42 to the retracted position 44, thereby disengaging the OD connection with the one or more other sleds of the OD chassis. In particular, the levers 50 of each segment 16 can be moved or pushed for moving each segment 16 from the advanced position 42 to the retracted position 44.

In a further step 144 of the method 140, the sled is removed from the OD chassis.

In a further optional step 146 of the method 140 before the step 142, each segment 16 of the sled is unlocked from the advanced position 42. In particular, each segment 16 can be initially locked in the advanced position 42. Therefore, the at least one lever 50 of each segment 16 of the sled can be initially engaged with the respective first hole 52 of the corresponding guiding elements 46. In step 146, the levers 50 of each segment 16 can be released from the respective first holes 52 to unlock each segment 16 from the advanced position 42.

In a further optional step 148 of the method 140 after the step 142, each segment 16 is locked in the retracted position 44. In particular, the levers 50 of each segment 16 can be engaged with the respective second holes 54 of the corresponding guiding elements 46 to lock each segment 16 in the retracted position 44.

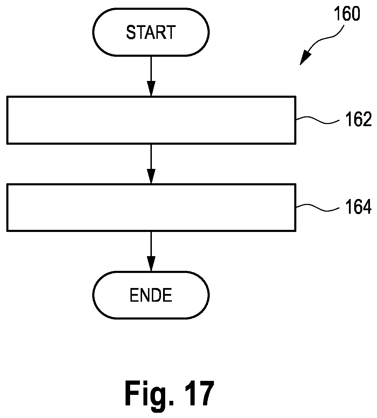

Fig. 17 shows a flow diagram for explaining an exemplary embodiment of a method for replacing a sled in an OD chassis designated by reference number 160 in its entirety.

In a first step 162 of the method 160, a sled from the OD chassis is removed using the method 140 as shown in Fig. 16.

In a further step 164 of the method 160, a replacement sled is inserted in the OD chassis using the method 120 as shown in Fig. 15. The replacement sled in inserted into the same slot from which the old sled has been removed in step 162.

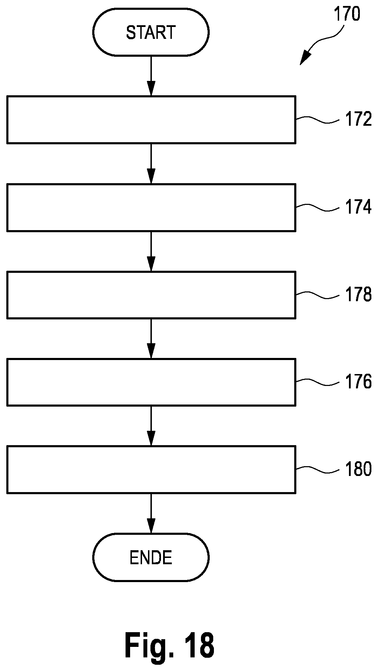

Fig. 18 shows a flow diagram for explaining an exemplary embodiment of a method for inserting a sled in an OD chassis designated by reference number 170 in its entirety. The sled establishes an OD connection with one or more other sleds of the OD chassis when the sled is inserted in the OD chassis. The one or more other sleds are configured as sleds according to the sled of any of the first to fourth exemplary embodiments shown in Figs. 1 to 11. The method 120 can be used to insert the sled into an empty slot of the OD chassis of the first or second embodiment shown in Figs. 12 to 14. The first part 18 of each segment 16 of the one or more other sleds is movable parallel to a movement direction 40 between an advanced position 42 and a retracted position 44.

In a first step 172 of the method 170, the first part 18 of each segment 16 of the one or more other sleds is arranged in the retracted position 44.

In a further step 174 of the method 170, the sled is inserted into the OD chassis. In particular, the sled is inserted in the respective empty slot of the OD chassis.

In a further step 176 of the method 170, the first part 18 of each segment 16 of the one or more other sleds is moved from the retracted position 44 to the advanced position 42, thereby establishing the OD connection with the sled. In particular, the levers 50 of each segment 16 can be moved or pushed for moving each segment 16 from the retracted position 44 to the advanced position 42.

Optionally, in the step 172, each segment 16 of each of the one or more other sleds can be locked in the retracted position 44. Therefore, the at least one lever 50 of each segment 16 can be initially engaged with the respective second holes 54 of the corresponding guiding elements 46.

In a further optional step 178 of the method 170 before the step 176 and after the step 174, each segment 16 of the one or more other sleds is unlocked from the retracted position 44. In particular, the levers 50 of each segment 16 can be released from the respective second holes 54 to unlock each segment 16 from the retracted position 44.

In a further optional step 180 of the method 170 after the step 178, each segment 16 of the one or more other sleds is locked in the advanced position 42. In particular, the levers 50 of each segment 16 can be engaged with the respective first holes 52 of the corresponding guiding elements 46 to lock each segment 16 in the advanced position 42.

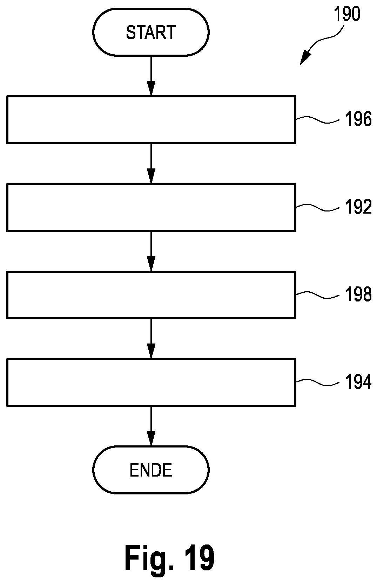

Fig. 19 shows a flow diagram for explaining an exemplary embodiment of a method for removing a sled from an OD chassis designated by reference number 190 in its entirety. The sled establishes an OD connection with one or more other sleds of the OD chassis when the sled is inserted in the OD chassis. The one or more other sleds are configured as sleds according to the sled of any of the first to fourth exemplary embodiments shown in Figs. 1 to 11. The method 120 can be used to remove the sled from a slot of the OD chassis of the first or second embodiment shown in Figs. 12 to 14. The first part 18 of each segment 16 of the one or more other sleds is movable parallel to a movement direction 40 between an advanced position 42 and a retracted position 44. Initially, the sled is inserted in the OD chassis in the OD connection is established with the one or more other sleds of the OD chassis. In particular, the first part 18 of each segment 16 of the one or more other sleds can initially be arranged in the advanced position 42.

In a first step 192 of the method 190, the first part 18 of each segment 16 of the one or more other sleds is moved from the advanced position 42 to the retracted position 44, thereby disengaging the OD connection with the one or more other sleds of the OD chassis. In particular, the levers 50 of each segment 16 can be moved or pushed for moving each segment 16 from the advanced position 42 to the retracted position 44.

In a further step 194 of the method 190, the sled is removed from the OD chassis.

In a further optional step 196 of the method 190 before the step 192, each segment 16 of the one or more other sleds is unlocked from the advanced position 42. In particular, each segment 16 can be initially locked in the advanced position 42. Therefore, the at least one lever 50 of each segment 16 can be initially engaged with the respective first hole 52 of the corresponding guiding elements 46. In step 196, the levers 50 of each segment 16 can be released from the respective first holes 52 to unlock each segment 16 from the advanced position 42.

In a further optional step 198 of the method 190 after the step 192, each segment 16 of the one or more other sleds is locked in the retracted position 44. In particular, the levers 50 of each segment 16 can be engaged with the respective second holes 54 of the corresponding guiding elements 46 to lock each segment 16 in the retracted position 44.

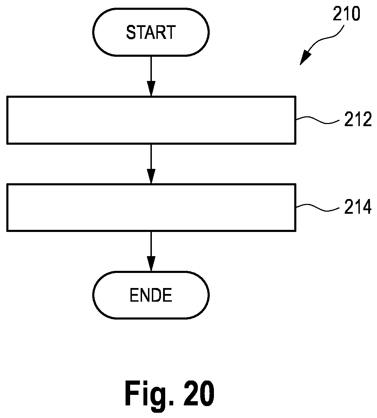

Fig. 20 shows a flow diagram for explaining an exemplary embodiment of a method for replacing a sled in an OD chassis designated by reference number 210 in its entirety.

In a first step 212 of the method 210, a sled is removed from the OD chassis using the method 190 as shown in Fig. 19.

In a further step 214 of the method 210, a replacement sled is inserted in the OD chassis using the method 170 as shown in Fig. 18. The replacement sled in inserted into the same slot from which the old sled has been removed in step 212.

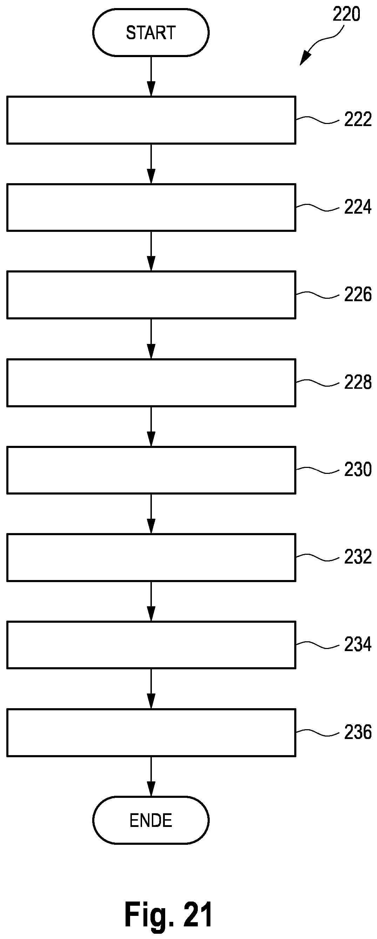

Fig. 21 shows a flow diagram for explaining an exemplary embodiment of a method for assembling a sled for an orthogonal-direct, OD, chassis designated by reference number 220 in its entirety. The method 220 can be used to assemble a sled according to any of the first to fourth exemplary embodiments as described in conjunction with the Figures 1 to 11.

In a first step 222 of the method 220, a frame 12 is provided.

In a further step 224 of the method 220, a plurality of connection elements 14 are provided for establishing an OD connection with one or more other sleds of the OD chassis.

In a further step 226 of the method 220, one or more segments 16 are provided. Each segment 16 comprises a first part 18. Each segment 16 can further comprise a second part 20.

In a further optional step 228 of the method 220, one or more electronic components are provided. In particular, the one or more electronic components can comprise fabric chips, processor units, or utilities.

In a further step 230 of the method 220, one or more of the connection elements 14 are mounted to the first part 18 of each segment 16.

In a further step 232 of the method 220, each segment 16 is arranged within the frame 12 such that at least the first part 18 of each segment 16 is movable relative to the frame 12. For instance, the first part 18 of each segment 16 can be movably mounted to the frame 12. Alternatively, each segment 16 can be movably mounted to the frame 12. Alternatively, the second part 20 of each segment 16 can be fixedly mounted to the frame 12 and the first part 18 of each segment 16 can be movably mounted to the second part 20 of the respective segment 16. Each segment 16 or the first part 18 of each segment 16 can be mounted in a floating manner within the frame 12. Further, each segment 16 or the first part 18 of each segment 16 can be movably mounted within the frame such that the first part 18 of each segment 16 is movable parallel to a movement direction 40 between an advanced position 42 and a retracted position 44.

In a further optional step 234 of the method 220, the one or more electronic components are arranged within the frame 12. In particular, one or more electronic components can be mounted to the frame 12. Alternatively, the one or more electronic components can be mounted to one or more of the segments 16. Alternatively, the one or more electronic components can be mounted to the second part 20 of one or more of the segments 16.

In a further optional step 236 of the method 220, the connection elements 14 are connected to the one or more electronic components via cables. The cables can be electrical cables or optical cables.

## Claims

1. A sled (10, 70, 80, 84) for an orthogonal-direct, OD, chassis (90, 100), wherein the sled (10, 70, 80, 84) comprises:
- a frame (12);
- a plurality of connection elements (14) for establishing an OD connection with one or more other sleds of the OD chassis (90, 100); and
- one or more segments (16), each segment (16) comprising a first part (18),
wherein each segment (16) is arranged within the frame (12), wherein one or more of the connection elements (14) are mounted to the first part (18) of each segment (16), and wherein the first part (18) of each segment (16) is movable relative to the frame (12).

2. The sled (10, 70, 80, 84) according to claim 1, wherein each segment (16) or the first part (18) of each segment (16) is movably mounted to the frame (12).

3. The sled (10, 70, 80, 84) according to claim 1, wherein each segment (16) further comprises a second part (20), wherein the second part (20) of each segment (16) is mounted to the frame (12), wherein the first part (18) of each segment (16) is movably mounted to the second part (20) of the corresponding segment (16).

4. The sled (10, 70, 80, 84) according to any one of claims 1 to 3, wherein each segment (16) or the first part (18) of each segment (16) is mounted in a floating manner within the frame (12).

5. The sled (10, 70, 80, 84) according to claim 4, wherein each segment (16) or the frame (12) comprise one or more floating bearings for mounting each segment (16) or the first part (18) of each segment (16) in a floating manner.

6. The sled (10, 70, 80, 84) according to any one of claims 1 to 5, wherein the first part (18) of each segment (16) is movable parallel to a movement direction (40) between an advanced position (42) and a retracted position (44), wherein the OD connection is establishable when the first part (18) of each segment (16) is arranged in the advanced position (42).

7. The sled (10, 70, 80, 84) according to claim 6, wherein the frame (12) comprises guiding elements (46) extending in the movement direction (40), wherein the guiding elements (46) guide the movement of each segment (16) or the movement of the first part (18) of each segment (16) in the movement direction (40).

8. The sled (10, 70, 80, 84) according to any claim 7, wherein each guiding element (46) comprises one or more floating bearings for mounting the corresponding segment (16) or the first part of the segment (16) in a floating manner.

9. The sled (10, 70, 80, 84) according to any one of claims 1 to 8, wherein the first part (18) of each segment (16) is lockable in the advanced position (42), in particular wherein the first part (18) of each segment (16) is lockable in the retracted position (44).

10. The sled (10, 70, 80, 84) according to claim 9, wherein each segment (16) comprises one or more levers (50), wherein the guiding elements (46) comprise, for each lever (50), a first hole (52) and a second hole (54), wherein the lever (50) is engageable with the corresponding first hole (52) for locking the first part (18) of the segment (16) in the advanced position (42), wherein the lever (50) is engageable with the corresponding second hole (54) for locking the first part (18) of the segment (16) in the retracted position (44).

11. The sled (10, 70, 80, 84) according to any one of claims 1 to 10, wherein the sled (10, 70, 80, 84) comprises one or more electronic component (74, 82), wherein the connection elements (14) are connected to the electronic components (74, 82) via cables (76).

12. An orthogonal-direct, OD, chassis (90, 100), comprising:
- one or more horizontal sleds (94, 102); and
- one or more vertical sleds (96, 104, 106),
wherein each horizontal sled (94, 102) is connectable to each vertical sled (96, 104, 106) using an OD connection (98, 108), and wherein the one or more horizontal sleds (94, 102) and/or the one or more vertical sleds (96, 104, 106) are configured as sleds (10, 70, 80, 84) according to any one of the claims 1 to 11.

13. The OD chassis (90, 100) according to claim 12, wherein each horizontal sled (94, 102) comprises a plurality of first connection elements, wherein each vertical sled (96, 104, 106) comprises a plurality of second connection elements, and wherein the first connection elements and the second connection elements are connectable to each other to establish the OD connection.

14. A method (120) for inserting a sled in an OD chassis, wherein the sled establishes an OD connection with one or more other sleds of the OD chassis when the sled is inserted in the OD chassis, wherein the sled is configured as a sled (10, 70, 80, 84) according to any one of the claims 1 to 11, wherein the first part (18) of each segment (16) is movable parallel to a movement direction (40) between an advanced position (42) and a retracted position (44), wherein the method (120) comprises the following steps:
- arranging (122) the first part (18) of each segment (16) of the sled in the retracted position (44);
- inserting (124) the sled into the OD chassis; and
- moving (126) the first part (18) of each segment (16) of the sled from the retracted position (44) to an advanced position (42), thereby establishing the OD connection with the one or more other sleds of the OD chassis.

15. A method (170) for inserting a sled in an orthogonal-direct, OD, chassis, wherein the sled establishes an OD connection with one or more other sleds of the OD chassis when the sled is inserted in the OD chassis, wherein the one or more other sleds are configured as sleds (10, 70, 80, 84) according to any one of the claims 1 to 11, wherein the first part (18) of each segment (16) of the one or more other sleds is movable parallel to a movement direction (40) between an advanced position (42) and a retracted position (44), wherein the method (170) comprises the following steps:
- arranging (172) the first part (18) of each segment (16) of the one or more other sleds in the retracted position (42);
- inserting (174) the sled into the OD chassis; and
- moving (176) the first part (18) of each segment (16) of the one or more other sleds from the retracted position (44) to the advanced position (42), thereby establishing the OD connection with the sled.

## Patentansprüche

1. Einschubmodul (10, 70, 80, 84) für ein orthogonal-direktes, OD, Chassis (90, 100), wobei das Einschubmodul (10, 70, 80, 84) aufweist:
- einen Rahmen (12);
- eine Mehrzahl von Verbindungselementen (14) zum Herstellen einer OD-Verbindung mit einem oder mehreren anderen Einschubmodulen des OD-Chassis (90, 100); und
- ein oder mehrere Segmente (16), wobei jedes Segment (16) einen ersten Teil (18) aufweist,
wobei jedes Segment (16) innerhalb des Rahmens (12) angeordnet ist, wobei eines oder mehrere der Verbindungselemente (14) an dem ersten Teil (18) jedes Segments (16) montiert sind, und wobei der erste Teil (18) jedes Segments (16) relativ zu dem Rahmen (12) beweglich ist.

2. Einschubmodul (10, 70, 80, 84) nach Anspruch 1, wobei jedes Segment (16) oder der erste Teil (18) jedes Segments (16) beweglich an dem Rahmen (12) montiert ist.

3. Einschubmodul (10, 70, 80, 84) nach Anspruch 1, wobei jedes Segment (16) des Weiteren einen zweiten Teil (20) aufweist, wobei der zweite Teil (20) jedes Segments (16) an dem Rahmen (12) montiert ist, wobei der erste Teil (18) jedes Segments (16) beweglich an dem zweiten Teil (20) des entsprechenden Segments (16) montiert ist.

4. Einschubmodul (10, 70, 80, 84) nach einem der Ansprüche 1 bis 3, wobei jedes Segment (16) oder der erste Teil (18) jedes Segments (16) in einer schwimmenden Weise innerhalb des Rahmens (12) montiert ist.

5. Einschubmodul (10, 70, 80, 84) nach Anspruch 4, wobei jedes Segment (16) oder der Rahmen (12) ein oder mehrere schwimmende Lager zum Montieren jedes Segments (16) oder des ersten Teils (18) jedes Segments (16) in einer schwimmenden Weise aufweist.

6. Einschubmodul (10, 70, 80, 84) nach einem der Ansprüche 1 bis 5, wobei der erste Teil (18) jedes Segments (16) parallel zu einer Bewegungsrichtung (40) zwischen einer vorgeschobenen Position (42) und einer zurückgezogenen Position (44) beweglich ist, wobei die OD-Verbindung herstellbar ist, wenn der erste Teil (18) jedes Segments (16) in der vorgeschobenen Position (42) angeordnet ist.

7. Einschubmodul (10, 70, 80, 84) nach Anspruch 6, wobei der Rahmen (12) Führungselemente (46) aufweist, die sich in der Bewegungsrichtung (40) erstrecken, wobei die Führungselemente (46) die Bewegung jedes Segments (16) oder die Bewegung des ersten Teils (18) jedes Segments (16) in der Bewegungsrichtung (40) führen.

8. Einschubmodul (10, 70, 80, 84) nach Anspruch 7, wobei jedes Führungselement (46) ein oder mehrere schwimmende Lager zum Montieren des entsprechenden Segments (16) oder des ersten Teils des Segments (16) in einer schwimmenden Weise aufweist.

9. Einschubmodul (10, 70, 80, 84) nach einem der Ansprüche 1 bis 8, wobei der erste Teil (18) jedes Segments (16) in der vorgeschobenen Position (42) verriegelbar ist, insbesondere wobei der erste Teil (18) jedes Segments (16) in der zurückgezogenen Position (44) verriegelbar ist.

10. Einschubmodul (10, 70, 80, 84) nach Anspruch 9, wobei jedes Segment (16) einen oder mehrere Hebel (50) aufweist, wobei die Führungselemente (46) für jeden Hebel (50) ein erstes Loch (52) und ein zweites Loch (54) aufweisen, wobei der Hebel (50) mit dem entsprechenden ersten Loch (52) in Eingriff bringbar ist, um den ersten Teil (18) des Segments (16) in der vorgeschobenen Position (42) zu verriegeln, wobei der Hebel (50) mit dem entsprechenden zweiten Loch (54) in Eingriff bringbar ist, um den ersten Teil (18) des Segments (16) in der zurückgezogenen Position (44) zu verriegeln.

11. Einschubmodul (10, 70, 80, 84) nach einem der Ansprüche 1 bis 10, wobei das Einschubmodul (10, 70, 80, 84) eine oder mehrere elektronische Komponenten (74, 82) aufweist, wobei die Verbindungselemente (14) über Kabel (76) mit den elektronischen Komponenten (74, 82) verbunden sind.

12. Orthogonal-direktes, OD, Chassis (90, 100), aufweisend:
- ein oder mehrere horizontale Einschubmodule (94, 102); und
- ein oder mehrere vertikale Einschubmodule (96, 104, 106),
wobei jedes horizontale Einschubmodul (94, 102) mit jedem vertikalen Einschubmodul (96, 104, 106) unter Verwendung einer OD-Verbindung (98, 108) verbindbar ist, und wobei die eine oder mehreren horizontalen Einschubmodule (94, 102) und/oder die eine oder mehreren vertikalen Einschubmodule (96, 104, 106) als Einschubmodule (10, 70, 80, 84) nach einem der Ansprüche 1 bis 11 konfiguriert sind.

13. OD-Chassis (90, 100) nach Anspruch 12, wobei jedes horizontale Einschubmodul (94, 102) eine Mehrzahl von ersten Verbindungselementen aufweist, wobei jedes vertikale Einschubmodul (96, 104, 106) eine Mehrzahl von zweiten Verbindungselementen aufweist, und wobei die ersten Verbindungselemente und die zweiten Verbindungselemente miteinander verbindbar sind, um die OD-Verbindung herzustellen.

14. Verfahren (120) zum Einsetzen eines Einschubmoduls in ein OD-Chassis, wobei das Einschubmodul eine OD-Verbindung mit einem oder mehreren anderen Einschubmodulen des OD-Chassis herstellt, wenn das Einschubmodul in das OD-Chassis eingesetzt wird, wobei das Einschubmodul als ein Einschubmodul (10, 70, 80, 84) nach einem der Ansprüche 1 bis 11 konfiguriert ist, wobei der erste Teil (18) jedes Segments (16) parallel zu einer Bewegungsrichtung (40) zwischen einer vorgeschobenen Position (42) und einer zurückgezogenen Position (44) beweglich ist, wobei das Verfahren (120) die folgenden Schritte aufweist:
- Anordnen (122) des ersten Teils (18) jedes Segments (16) des Einschubmoduls in der zurückgezogenen Position (44);
- Einsetzen (124) des Einschubmoduls in das OD-Chassis; und
- Bewegen (126) des ersten Teils (18) jedes Segments (16) des Einschubmoduls von der zurückgezogenen Position (44) zu einer vorgeschobenen Position (42), wodurch die OD-Verbindung mit einem oder mehreren anderen Einschubmodulen des OD-Chassis hergestellt wird.

15. Verfahren (170) zum Einsetzen eines Einschubmoduls in ein orthogonal-direktes, OD, Chassis, wobei das Einschubmodul eine OD-Verbindung mit einem oder mehreren anderen Einschubmodulen des OD-Chassis herstellt, wenn das Einschubmodul in das OD-Chassis eingesetzt ist, wobei die eine oder mehreren anderen Einschubmodule als Einschubmodule (10, 70, 80, 84) nach einem der Ansprüche 1 bis 11 konfiguriert sind, wobei der erste Teil (18) jedes Segments (16) der einen oder mehreren anderen Einschubmodule parallel zu einer Bewegungsrichtung (40) zwischen einer vorgeschobenen Position (42) und einer zurückgezogenen Position (44) beweglich ist, wobei das Verfahren (170) die folgenden Schritte aufweist:
- Anordnen (172) des ersten Teils (18) jedes Segments (16) der einen oder mehreren anderen Einschubmodule in der zurückgezogenen Position (42);
- Einsetzen (174) des Einschubmoduls in das OD-Chassis; und
- Bewegen (176) des ersten Teils (18) jedes Segments (16) der einen oder mehreren anderen Einschubmodule von der zurückgezogenen Position (44) in die vorgeschobene Position (42), wodurch die OD-Verbindung mit dem Einschubmodul hergestellt wird.

## Revendications

1. Module (10, 70, 80, 84) pour un châssis à liaison orthogonale directe, OD, (90, 100), dans lequel le module (10, 70, 80, 84) comprend :
- un cadre (12) ;
- une pluralité d'éléments de liaison (14) pour établir une liaison OD avec un ou plusieurs autres modules du châssis OD (90, 100) ; et
- un ou plusieurs segments (16), chaque segment (16) comprenant une première partie (18),
dans lequel chaque segment (16) est agencé à l'intérieur du cadre (12), dans lequel un ou plusieurs des éléments de liaison (14) sont montés sur la première partie (18) de chaque segment (16), et dans lequel la première partie (18) de chaque segment (16) est mobile par rapport au cadre (12).

2. Module (10, 70, 80, 84) selon la revendication 1, dans lequel chaque segment (16) ou la première partie (18) de chaque segment (16) est monté(e) de manière mobile sur le cadre (12).

3. Module (10, 70, 80, 84) selon la revendication 1, dans lequel chaque segment (16) comprend en outre une seconde partie (20), dans lequel la seconde partie (20) de chaque segment (16) est montée sur le cadre (12), dans lequel la première partie (18) de chaque segment (16) est montée de manière mobile sur la seconde partie (20) du segment correspondant (16).

4. Module (10, 70, 80, 84) selon l'une quelconque des revendications 1 à 3, dans lequel chaque segment (16) ou la première partie (18) de chaque segment (16) est monté(e) de manière flottante à l'intérieur du cadre (12).

5. Module (10, 70, 80, 84) selon la revendication 4, dans lequel chaque segment (16) ou le cadre (12) comprend un ou plusieurs paliers flottants pour monter chaque segment (16) ou la première partie (18) de chaque segment (16) de manière flottante.

6. Module (10, 70, 80, 84) selon l'une quelconque des revendications 1 à 5, dans lequel la première partie (18) de chaque segment (16) est mobile parallèlement à une direction de déplacement (40) entre une position avancée (42) et une position rétractée (44), dans lequel la liaison OD peut être établie lorsque la première partie (18) de chaque segment (16) est agencée dans la position avancée (42).

7. Module (10, 70, 80, 84) selon la revendication 6, dans lequel le cadre (12) comprend des éléments de guidage (46) s'étendant dans la direction de déplacement (40), dans lequel les éléments de guidage (46) guident le déplacement de chaque segment (16) ou le déplacement de la première partie (18) de chaque segment (16) dans la direction de déplacement (40).

8. Module (10, 70, 80, 84) selon la revendication 7, dans lequel chaque élément de guidage (46) comprend un ou plusieurs paliers flottants pour monter le segment correspondant (16) ou la première partie du segment (16) de manière flottante.

9. Module (10, 70, 80, 84) selon l'une quelconque des revendications 1 à 8, dans lequel la première partie (18) de chaque segment (16) est verrouillable dans la position avancée (42), en particulier dans lequel la première partie (18) de chaque segment (16) est verrouillable dans la position rétractée (44).

10. Module (10, 70, 80, 84) selon la revendication 9, dans lequel chaque segment (16) comprend un ou plusieurs leviers (50), dans lequel les éléments de guidage (46) comprennent, pour chaque levier (50), un premier trou (52) et un second trou (54), dans lequel le levier (50) peut s'engager avec le premier trou correspondant (52) pour verrouiller la première partie (18) du segment (16) dans la position avancée (42), dans lequel le levier (50) peut s'engager avec le second trou correspondant (54) pour verrouiller la première partie (18) du segment (16) dans la position rétractée (44).

11. Module (10, 70, 80, 84) selon l'une quelconque des revendications 1 à 10, dans lequel le module (10, 70, 80, 84) comprend un ou plusieurs composants électroniques (74, 82), dans lequel les éléments de liaison (14) sont reliés aux composants électroniques (74, 82) par l'intermédiaire de câbles (76).

12. Châssis à liaison orthogonale directe, OD, (90, 100), comprenant :
- un ou plusieurs modules horizontaux (94, 102) ; et
- un ou plusieurs modules verticaux (96, 104, 106),
dans lequel chaque module horizontal (94, 102) peut être relié à chaque module vertical (96, 104, 106) en utilisant une liaison OD (98, 108), et dans lequel le ou les plusieurs modules horizontaux (94, 102) et/ou le ou les plusieurs modules verticaux (96, 104, 106) sont configurés en tant que modules (10, 70, 80, 84) selon l'une quelconque des revendications 1 à 11.

13. Châssis OD (90, 100) selon la revendication 12, dans lequel chaque module horizontal (94, 102) comprend une pluralité de premiers éléments de liaison, dans lequel chaque module vertical (96, 104, 106) comprend une pluralité de seconds éléments de liaison, et dans lequel les premiers éléments de liaison et les seconds éléments de liaison peuvent être reliés les uns aux autres pour établir la liaison OD.

14. Procédé (120) d'insertion d'un module dans un châssis OD, dans lequel le module établit une liaison OD avec un ou plusieurs autres modules du châssis OD lorsque le module est inséré dans le châssis OD, dans lequel le module est configuré en tant que module (10, 70, 80, 84) selon l'une quelconque des revendications 1 à 11, dans lequel la première partie (18) de chaque segment (16) est mobile parallèlement à une direction de déplacement (40) entre une position avancée (42) et une position rétractée (44), dans lequel le procédé (120) comprend les étapes suivantes :
- agencement (122) de la première partie (18) de chaque segment (16) du module dans la position rétractée (44) ;
- insertion (124) du module dans le châssis OD ; et
- déplacement (126) de la première partie (18) de chaque segment (16) du module de la position rétractée (44) vers une position avancée (42), établissant ainsi la liaison OD avec le ou les plusieurs autres modules du châssis OD.

15. Procédé (170) d'insertion d'un module dans un châssis à liaison orthogonale directe, OD, dans lequel le module établit une liaison OD avec un ou plusieurs autres modules du châssis OD lorsque le module est inséré dans le châssis OD, dans lequel le ou les plusieurs autres modules sont configurés en tant que modules (10, 70, 80, 84) selon l'une quelconque des revendications 1 à 11, dans lequel la première partie (18) de chaque segment (16) du ou des plusieurs autres modules est mobile parallèlement à une direction de déplacement (40) entre une position avancée (42) et une position rétractée (44), dans lequel le procédé (170) comprend les étapes suivantes :
- agencement (172) de la première partie (18) de chaque segment (16) du ou des plusieurs autres modules dans la position rétractée (42) ;
- insertion (174) du module dans le châssis OD ; et
- déplacement (176) de la première partie (18) de chaque segment (16) du ou des plusieurs autres modules de la position rétractée (44) vers la position avancée (42), établissant ainsi la liaison OD avec le module.
